(19) Europäisches Patentamt
European Patent Office
Office européen des brevets

(11) **EP 3 291 008 A1**

(12) **EUROPEAN PATENT APPLICATION**

(43) Date of publication:
**07.03.2018 Bulletin 2018/10**

(51) Int Cl.:
***G03F 7/20*** *(2006.01)*

(21) Application number: **16187478.9**

(22) Date of filing: **06.09.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ASML Netherlands B.V.**
**5500 AH Veldhoven (NL)**

(72) Inventors:
• **MASLOW, Mark, John**
**5500 AH Veldhoven (NL)**
• **MULKENS, Johannes, Catharinus, Hubertus**
**5500 AH Veldhoven (NL)**

• **TEN BERGE, Peter**
**5500 AH Veldhoven (NL)**
• **VAN DE MAST, Franciscus**
**5500 AH Veldhoven (NL)**
• **GEMMINK, Jan-Willem**
**5500 AH Veldhoven (NL)**
• **REIJNEN, Liesbeth**
**5500 AH Veldhoven (NL)**

(74) Representative: **Peters, John Antoine**
**ASML Netherlands BV**
**Corporate Intellectual Property**
**P.O. Box 324**
**5500 AH Veldhoven (NL)**

Remarks:
Claims 16-46 are deemed to be abandoned due to non-payment of the claims fees (Rule 45(3) EPC).

(54) **METHOD AND APPARATUS TO MONITOR A PROCESS APPARATUS**

(57) A substrate, including a substrate layer; and an etchable layer on the substrate layer, the etchable layer including a patterned region thereon or therein and including a blank region of sufficient size to enable an etch rate of an etch tool for etching the blank region to be determined.

FIG. 7G

EP 3 291 008 A1

**Description**

<u>FIELD</u>

The present description relates to a method and apparatus for monitoring and/or adjusting one or more manufacturing variables related to the processing of a substrate.

<u>BACKGROUND</u>

A lithographic apparatus is a machine that applies a desired pattern onto a substrate, usually onto a target portion of the substrate. A lithographic apparatus can be used, for example, in the manufacture of integrated circuits (ICs) or other devices designed to be functional. In that instance, a patterning device, which is alternatively referred to as a mask or a reticle, may be used to generate a circuit pattern to be formed on an individual layer of the device designed to be functional. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti parallel to this direction. It is also possible to transfer the pattern from the patterning device to the substrate by imprinting the pattern onto the substrate.

<u>SUMMARY</u>

Manufacturing devices, such as semiconductor devices, typically involves processing a substrate (e.g., a semiconductor wafer) using a number of fabrication processes to form various features and often multiple layers of the devices. Such layers and/or features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a lithographic apparatus, to provide a pattern on a substrate and typically, but optionally, involves one or more related pattern processing steps, such as resist development by a development apparatus, baking of the substrate using a bake tool, etching the pattern by an etch apparatus, etc. Further, one or more metrology processes are involved in the patterning process.

Metrology processes are used at various steps during a patterning process to monitor and/or control the process. For example, metrology processes are used to measure one or more characteristics of a substrate, such as a relative location (e.g., registration, overlay, alignment, etc.) or dimension (e.g., line width, critical dimension (CD), thickness, etc.) of features formed on the substrate during the patterning process, such that, for example, the performance of the patterning process can be determined from the one or more characteristics. If the one or more characteristics are unacceptable (e.g., out of a predetermined range for the characteristic(s)), one or more variables of the patterning process may be altered, e.g., based on the measurements of the one or more characteristics, such that further substrates manufactured by the patterning process have an acceptable characteristic(s).

With the advancement of lithography and other patterning process technologies, the dimensions of functional elements have continually been reduced while the amount of the functional elements, such as transistors, per device has been steadily increased over decades. In the meanwhile, the requirement of accuracy in terms of overlay, critical dimension (CD), etc. has become more and more stringent. Error, such as overlay error, CD error, etc., will inevitably be produced in the patterning process. For example, imaging error may be produced from optical aberration, patterning device heating, patterning device error, and/or substrate heating and can be characterized in terms of, e.g., overlay error, CD error, etc. Additionally or alternatively, error may be introduced in other parts of the patterning process, such as in etch, development, bake, etc. and similarly can be characterized in terms of, e.g., overlay error, CD error, etc. The error may directly cause a problem in terms of the functioning of the device, including failure of the device to function or one or more electrical problems of the functioning device.

A lithography baseliner system may be used to monitor the performance of a lithographic apparatus over time. When performance of the lithographic apparatus deviates from an acceptable standard, an action can be taken, such as re-calibration, repair, shutdown, etc. Further, the lithographic baseliner system can enable timely control of the lithographic apparatus by, for example, modifying one or more settings (variables) of the lithographic apparatus. Thus, a lithography baseliner system can enable, e.g., stable performance in high volume manufacturing (HVM).

The lithography baseliner system can effectively aim to keep the lithographic apparatus to a certain baseline.

To do this, in an embodiment, the lithography baseliner system obtains measurements taken on a monitor wafer using a metrology tool (such as a diffraction based optical measurement tool). In an embodiment, the monitor wafer can be exposed using a certain patterning device pattern comprising marks suitable for the metrology tool. From the measurements, the lithography baseliner system determines how far the lithographic apparatus has drifted from its baseline. In an embodiment, the lithography baseliner system then calculates, e.g., substrate-level overlay and/or focus correction sets. The lithographic apparatus then uses these correction sets to make specific corrections for exposure of subsequent production wafers.

A similar baseliner is desirable for a non-lithography process apparatus, for example, a track, an etch tool, a deposition tool, a chemical mechanical planarization (CMP) tool, etc. Therefore, it is desirable to provide a method and/or an apparatus that can better monitor and/or control the performance of the non-lithographic process apparatuses.

In an embodiment, there is provided a substrate, comprising: a substrate layer; and an etchable layer on the substrate layer, the etchable layer comprising a patterned region thereon or therein and comprising a blank region of sufficient size to enable an etch rate of an etch tool for etching the blank region to be determined.

In an embodiment, there is provided a method, comprising: evaluating a pattern on a substrate after the substrate has been processed by a process tool upstream or downstream from a lithography tool, to determine a value of a characteristic of the evaluated pattern; determining whether the value of the characteristic of the evaluated pattern meets a target value of the characteristic; and responsive to a determination that the value of the characteristic of the evaluated pattern does not meet the target value of the characteristic, creating and outputting, by a hardware computer system and based at least in part on the determination, information regarding the process tool.

In an embodiment, there is provided a method, comprising: providing a substrate that includes a substrate layer and an etchable layer on the substrate layer, the etchable layer having a first patterned region thereon or therein and a blank region; etching, with an etch tool, at least part of the patterned region to form a second patterned region in the etchable layer; and evaluating a characteristic of the second patterned region; and creating and outputting, by a hardware computer system, information regarding the etch tool based on the evaluated characteristic.

In an aspect, there is provided a non-transitory computer program product comprising machine-readable instructions for causing a processor system to cause performance of a method described herein.

In an embodiment, there is provided a system comprising: a hardware processor system; and a non-transitory computer readable storage medium configured to store machine-readable instructions, wherein when executed, the machine-readable instructions cause the hardware processor system to perform a method as described herein.

BRIEF DESCRIPTION OF THE DRAWINGS

Embodiments will now be described, by way of example only, with reference to the accompanying drawings in which:

Figure 1 schematically depicts an embodiment of a lithographic apparatus;
Figure 2 schematically depicts an embodiment of a lithographic cell or cluster;
Figure 3A is schematic diagram of a measurement apparatus for use in measuring targets according to an embodiment using a first pair of illumination apertures providing certain illumination modes;
Figure 3B is a schematic detail of a diffraction spectrum of a target for a given direction of illumination;
Figure 3C is a schematic illustration of a second pair of illumination apertures providing further illumination modes in using a measurement apparatus for diffraction based overlay measurements;
Figure 3D is a schematic illustration of a third pair of illumination apertures combining the first and second pairs of apertures providing further illumination modes in using a measurement apparatus for diffraction based overlay measurements;
Figure 4 schematically depicts a form of multiple periodic structure (e.g., multiple grating) target and an outline of a measurement spot on a substrate;
Figure 5 schematically depicts an image of the target of Figure 4 obtained in the apparatus of Figure 3;
Figure 6 schematically depicts an embodiment of a process apparatus baseliner system;
Figures 7A-7F schematically depict a process of forming a pattern on a substrate and etching the pattern in an etchable layer;
Figure 7G schematically depicts a process of measuring a processed substrate using a metrology apparatus;
Figure 8 depicts an example flowchart of a method of adjusting one or more substrate manufacturing variables, according to an embodiment of the disclosure;
Figure 9 depicts an example flowchart of a method of adjusting one or more substrate manufacturing variables, according to an embodiment of the disclosure;
Fig. 10 schematically depicts an example inspection apparatus and metrology technique;
Fig. 11 schematically depicts an example inspection apparatus;

Fig. 12 illustrates the relationship between an illumination spot of an inspection apparatus and a metrology target;
Fig. 13 schematically depicts a process of deriving a plurality of variables of interest based on measurement data; and
Figure 14 schematically depicts a computer system which may implement embodiments of this disclosure.

## DETAILED DESCRIPTION

Before describing embodiments in detail, it is instructive to present an example environment in which embodiments may be implemented.

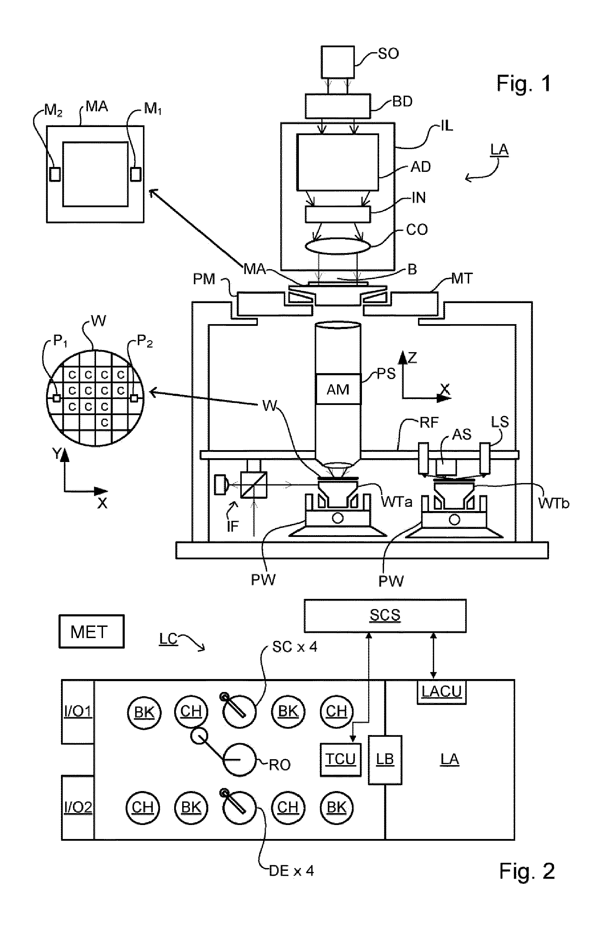

Figure 1 schematically depicts a lithographic apparatus LA. The apparatus comprises:

- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W, the projection system supported on a reference frame (RF).

The illumination system may include various types of optical components, such as refractive, reflective, magnetic, electromagnetic, electrostatic or other types of optical components, or any combination thereof, for directing, shaping, or controlling radiation.

The support structure supports the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a pattern in a target portion of the substrate. In an embodiment, a patterning device is any device that can be used to impart a radiation beam with a pattern in its cross-section so as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The projection system PS has an optical transfer function which may be non-uniform, which can affect the pattern imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be determined by calculating the inner product of a measured scalar map with each Zernike polynomial in turn and dividing this by the square of the norm of that Zernike polynomial.

The transmission map and the relative phase map are field and system dependent. That is, in general, each projection system PS will have a different Zernike expansion for each field point (i.e. for each spatial location in its image plane). The relative phase of the projection system PS in its pupil plane may be determined by projecting radiation, for example from a point-like source in an object plane of the projection system PS (i.e. the plane of the patterning device MA), through the projection system PS and using a shearing interferometer to measure a wavefront (i.e. a locus of points with the same phase). A shearing interferometer is a common path interferometer and therefore, advantageously, no secondary reference beam is required to measure the wavefront. The shearing interferometer may comprise a diffraction grating, for example a two dimensional grid, in an image plane of the projection system (i.e. the substrate table WT) and a detector arranged to detect an interference pattern in a plane that is conjugate to a pupil plane of the projection system PS. The interference pattern is related to the derivative of the phase of the radiation with respect to a coordinate in the pupil plane in the shearing direction. The detector may comprise an array of sensing elements such as, for example, charge coupled devices (CCDs).

The projection system PS of a lithography apparatus may not produce visible fringes and therefore the accuracy of the determination of the wavefront can be enhanced using phase stepping techniques such as, for example, moving the diffraction grating. Stepping may be performed in the plane of the diffraction grating and in a direction perpendicular to the scanning direction of the measurement. The stepping range may be one grating period, and at least three (uniformly distributed) phase steps may be used. Thus, for example, three scanning measurements may be performed in the y-direction, each scanning measurement being performed for a different position in the x-direction. This stepping of the diffraction grating effectively transforms phase variations into intensity variations, allowing phase information to be determined. The grating may be stepped in a direction perpendicular to the diffraction grating (z direction) to calibrate the detector.

The transmission (apodization) of the projection system PS in its pupil plane may be determined by projecting radiation, for example from a point-like source in an object plane of the projection system PS (i.e. the plane of the patterning device MA), through the projection system PS and measuring the intensity of radiation in a plane that is conjugate to a pupil plane of the projection system PS, using a detector. The same detector as is used to measure the wavefront to determine aberrations may be used.

The projection system PS may comprise a plurality of optical (e.g., lens) elements and may further comprise an adjustment mechanism AM configured to adjust one or more of the optical elements so as to correct for aberrations (phase variations across the pupil plane throughout the field). To achieve this, the adjustment mechanism may be operable to manipulate one or more optical (e.g., lens) elements within the projection system PS in one or more different ways. The projection system may have a coordinate system wherein its optical axis extends in the z direction. The adjustment mechanism may be operable to do any combination of the following: displace one or more optical elements; tilt one or more optical elements; and/or deform one or more optical elements. Displacement of an optical element may be in any direction (x, y, z or a combination thereof). Tilting of an optical element is typically out of a plane perpendicular to the optical axis, by rotating about an axis in the x and/or y directions although a rotation about the z axis may be used for a non-rotationally symmetric aspherical optical element. Deformation of an optical element may include a low frequency shape (e.g. astigmatic) and/or a high frequency shape (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PS to correct for apodization (transmission variation across the pupil plane). The transmission map of a projection system PS may be used when designing a patterning device (e.g., mask) MA for the lithography apparatus LA. Using a computational lithography technique, the patterning device MA may be designed to at least partially correct for apodization.

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines the additional tables may be used in parallel, or preparatory steps may be carried out on one or more tables while one or more other tables are being used for exposure. For example, alignment measurements using an alignment sensor AS and/or level (height, tilt, etc.) measurements using a level sensor LS may be made.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder, 2-D encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As shown in Figure 2, the lithographic apparatus LA may form part of a lithographic cell LC, also sometimes referred to a lithocell or cluster, which also includes apparatuses to perform pre- and post-exposure processes on a substrate. Conventionally these include one or more spin coaters SC to deposit one or more resist layers, one or more developers DE to develop exposed resist, one or more chill plates CH and/or one or more bake plates BK. A substrate handler, or robot, RO picks up one or more substrates from input/output port I/O1, I/O2, moves them between the different process apparatuses and delivers them to the loading bay LB of the lithographic apparatus. These apparatuses, which are often collectively referred to as the track, are under the control of a track control unit TCU which is itself controlled by the supervisory control system SCS, which also controls the lithographic apparatus via lithography control unit LACU. Thus, the different apparatuses can be operated to maximize throughput and processing efficiency.

In order that a substrate that is exposed by the lithographic apparatus is exposed correctly and consistently, it is desirable to inspect an exposed substrate to measure one or more properties such as overlay error between subsequent layers, line thickness, critical dimension (CD), focus offset, a material property, etc. Accordingly a manufacturing facility in which lithocell LC is located also typically includes a metrology system MET which receives some or all of the substrates W that have been processed in the lithocell. The metrology system MET may be part of the lithocell LC, for example it may be part of the lithographic apparatus LA.

Metrology results may be provided directly or indirectly to the supervisory control system SCS. If an error is detected, an adjustment may be made to exposure of a subsequent substrate (especially if the inspection can be done soon and fast enough that one or more other substrates of the batch are still to be exposed) and/or to subsequent exposure of the exposed substrate. Also, an already exposed substrate may be stripped and reworked to improve yield, or discarded, thereby avoiding performing further processing on a substrate known to be faulty. In a case where only some target portions of a substrate are faulty, further exposures may be performed only on those target portions which are good.

Within a metrology system MET, an inspection apparatus is used to determine one or more properties of the substrate, and in particular, how one or more properties of different substrates vary or different layers of the same substrate vary from layer to layer. The inspection apparatus may be integrated into the lithographic apparatus LA or the lithocell LC or may be a stand-alone device. To enable rapid measurement, it is desirable that the inspection apparatus measure one or more properties in the exposed resist layer immediately after the exposure. However, the latent image in the resist has a low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on an exposed substrate and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of a faulty substrate but may still provide useful information.

To enable the metrology, one or more targets can be provided on the substrate. In an embodiment, the target is specially designed and may comprise a periodic structure. In an embodiment, the target is a part of a device pattern, e.g., a periodic structure of the device pattern. A target used by a conventional scatterometer comprises a relatively large periodic structure layout (e.g., comprising one or more gratings), e.g., 40 $\mu$m by 40 $\mu$m In that case, the measurement beam often has a spot size that is smaller than the periodic structure layout (i.e., the layout is underfilled such that one or more of the periodic structures is not completely covered by the spot). This simplifies mathematical reconstruction of the target as it can be regarded as infinite. However, for example, so the target can be positioned in among product features, rather than in the scribe lane, the size of a target has been reduced, e.g., to 20 $\mu$m by 20 $\mu$m or less, or to 10 $\mu$m by 10 $\mu$m or less. In this situation, the periodic structure layout may be made smaller than the measurement spot (i.e., the periodic structure layout is overfilled). Typically such a target is measured using dark field scatterometry in which the zeroth order of diffraction (corresponding to a specular reflection) is blocked, and only higher orders processed. Examples of dark field metrology can be found in PCT patent application publication nos. WO 2009/078708 and WO 2009/106279, which are hereby incorporated in their entirety by reference. Further developments of the technique have been described in U.S. patent application publications US2011-0027704, US2011-0043791 and US2012-0242970, which are hereby incorporated in their entirety by reference. Diffraction-based overlay using dark-field detection of the diffraction orders enables overlay measurements on smaller targets. These targets can be smaller than the illumination spot and may be surrounded by product structures on a substrate. In an embodiment, multiple targets can be measured in one image.

In an embodiment, the target on a substrate may comprise one or more 1-D periodic gratings, which are printed such that after development, the bars are formed of solid resist lines. In an embodiment, the target may comprise one or more 2-D periodic gratings, which are printed such that after development, the one or more gratings are formed of solid resist pillars or vias in the resist. The bars, pillars or vias may alternatively be etched into the substrate.

In an embodiment, the pattern of the grating is sensitive to one or more processing attributes (e.g., chromatic aberration, focus, dose, etc.) of patterning process and the presence of such one or more attributes will manifest in a variation in the printed grating. For example, in an embodiment, the pattern of the grating is sensitive to one or more processing attributes (e.g., chromatic aberration, focus, dose, etc.) of the lithographic projection apparatus and the presence of such one or more attributes will manifest in a variation in the printed grating; the measurements of the grating can then be used to determine focus during exposure, dose during exposure, etc. In an embodiment, the pattern of the grating is sensitive to one or more non-lithographic process attributes (e.g., an attribute of deposition, an attribute of etching, an attribute of planarization, etc.) and the presence of such one or more attributes will manifest in a variation in the printed grating; the measurements of the grating can then be used to determine, e.g., film thickness uniformity (for deposition), etch rate uniformity (for etch), etch slant angle uniformity (for etch), and/or planarization dishing (for planarization such as CMP planarization).

Accordingly, the measured data of the printed gratings can be used to reconstruct the gratings and one or more characteristics of the patterning process. The parameters of the 1-D grating, such as line widths or shapes or 3-D profile characteristics, or parameters of the 2-D grating, such as pillar or via widths or lengths or shapes or 3-D profile characteristics, may be input to the reconstruction process, performed by processing unit PU, from knowledge of the printing step and/or other measurement processes.

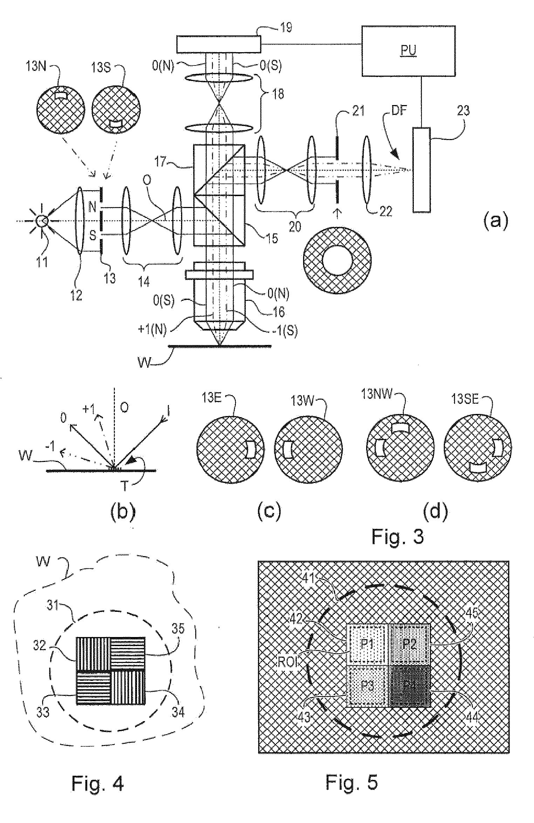

A metrology apparatus suitable for use in embodiments is shown in Figure 3A. A target T (comprising a periodic structure such as a grating) and diffracted rays are illustrated in more detail in Figure 3B. The dark field metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, radiation emitted by an output 11 (e.g., a source such as a laser or a xenon lamp or an opening connected to a source) is directed onto substrate W via a prism 15 by an optical system comprising lenses 12, 14 and objective lens 16. These lenses are arranged in a double sequence of a 4F arrangement. A different lens arrangement can be used, provided that it still provides a substrate image onto a detector.

In an embodiment, the lens arrangement allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done, for example, by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis illumination from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary radiation outside the desired illumination mode may interfere with the desired measurement signals.

As shown in Figure 3B, target T is placed with substrate W substantially normal to the optical axis O of objective lens 16. A ray of illumination I impinging on target T from an angle off the axis O gives rise to a zeroth order ray (solid line 0) and two first order rays (dot-chain line +1 and double dot-chain line -1). With an overfilled small target T, these rays are just one of many parallel rays covering the area of the substrate including metrology target T and other features. Since the aperture in plate 13 has a finite width (necessary to admit a useful quantity of radiation), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the periodic structure pitch and illumination angle can be designed or adjusted so that the first order rays entering the objective lens are closely aligned with the central optical axis. The rays illustrated in Figures 3A and 3B are shown somewhat off axis, purely to enable them to be more easily distinguished in the diagram. At least the 0 and +1 orders diffracted by the target on substrate W are collected by objective lens 16 and directed back through prism 15.

Returning to Figure 3A, both the first and second illumination modes are illustrated, by designating diametrically opposite apertures labeled as north (N) and south (S). When the incident ray I is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16. Thus, in an embodiment, measurement results are obtained by measuring the target twice under certain conditions, e.g., after rotating the target or changing the illumination mode or changing the imaging mode to obtain separately the -1st and the +1st diffraction order intensities. Comparing these intensities for a given target provides a measurement of asymmetry in the target, and asymmetry in the target can be used as an indicator of a parameter of a lithography process, e.g., overlay error. In the situation described above, the illumination mode is changed.

A beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction, which are not described in detail here.

In the second measurement branch, optical system 20, 22 forms an image of the target on the substrate W on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image DF of the target formed on sensor 23 is formed from the -1 or +1 first order beam. The images captured by sensors 19 and 23 are output to processor and controller PU, the function of which will depend on the particular type of measurements being performed. Note that the term 'image' is used here in a broad sense. An image of the periodic structure features (e.g., grating lines) as such will not be formed, if only one of the -1 and +1 orders is present.

The particular forms of aperture plate 13 and stop 21 shown in Figure 3 are purely examples. In another embodiment, on-axis illumination of the targets is used and an aperture stop with an off-axis aperture is used to pass substantially only one first order of diffracted radiation to the sensor. In yet other embodiments, 2nd, 3rd and higher order beams (not shown in Figure 3) can be used in measurements, instead of or in addition to the first order beams.

In order to make the illumination adaptable to these different types of measurement, the aperture plate 13 may comprise a number of aperture patterns formed around a disc, which rotates to bring a desired pattern into place. Note that aperture plate 13N or 13S are used to measure a periodic structure of a target oriented in one direction (X or Y depending on the set-up). For measurement of an orthogonal periodic structure, rotation of the target through 90° and 270° might be implemented. Different aperture plates are shown in Figures 3C and D. Figure 3C illustrates two further types of off-axis illumination mode. In a first illumination mode of Figure 3C, aperture plate 13E provides off-axis illumination from a direction designated, for the sake of description only, as 'east' relative to the 'north' previously described. In a second illumination mode of Figure 3C, aperture plate 13W is used to provide similar illumination, but from an opposite direction, labeled 'west'. Figure 3D illustrates two further types of off-axis illumination mode. In a first illumination mode of Figure 3D, aperture plate 13NW provides off-axis illumination from the directions designated 'north' and 'west' as previously described. In a second illumination mode, aperture plate 13SE is used to provide similar illumination, but from an opposite direction, labeled 'south' and 'east' as previously described. The use of these, and numerous other variations and applications of the apparatus are described in, for example, the prior published patent application publications mentioned above.

Figure 4 depicts an example composite metrology target formed on a substrate. The composite target comprises four periodic structures (in this case, gratings) 32, 33, 34, 35 positioned closely together. In an embodiment, the periodic structures are positioned closely together enough so that they all are within a measurement spot 31 formed by the illumination beam of the metrology apparatus. In that case, the four periodic structures thus are all simultaneously illuminated and simultaneously imaged on sensors 19 and 23. In an example dedicated to overlay measurement, periodic structures 32, 33, 34, 35 are themselves composite periodic structures (e.g., composite gratings) formed by overlying periodic structures, i.e., periodic structures are patterned in different layers of the device formed on substrate W and such that at least one periodic structure in one layer overlays at least one periodic structure in a different layer. Such a target may have outer dimensions within 20 $\mu$m x 20 $\mu$m or within 16 $\mu$m x 16 $\mu$m. Further, all the periodic structures are used to measure overlay between a particular pair of layers. To facilitate a target being able to measure more than a single pair of layers, periodic structures 32, 33, 34, 35 may have differently biased overlay offsets in order to facilitate measurement of overlay between different layers in which the different parts of the composite periodic structures are formed. Thus, all the periodic structures for the target on the substrate would be used to measure one pair of layers and all the periodic structures for another same target on the substrate would be used to measure another pair of layers, wherein the different bias facilitates distinguishing between the layer pairs.

Returning to Figure 4, periodic structures 32, 33, 34, 35 may also differ in their orientation, as shown, so as to diffract incoming radiation in X and Y directions. In one example, periodic structures 32 and 34 are X-direction periodic structures with biases of +d, -d, respectively. Periodic structures 33 and 35 may be Y-direction periodic structures with offsets +d and -d respectively. While four periodic structures are illustrated, another embodiment may include a larger matrix to obtain desired accuracy. For example, a 3 x 3 array of nine composite periodic structures may have biases -4d, -3d, -2d, -d, 0, +d, +2d, +3d, +4d. Separate images of these periodic structures can be identified in the image captured by sensor 23.

Figure 5 shows an example of an image that may be formed on and detected by the sensor 23, using the target of Figure 4 in the apparatus of Figure 3, using the aperture plates 13NW or 13SE from Figure 3D. While the sensor 19 cannot resolve the different individual periodic structures 32 to 35, the sensor 23 can do so. The dark rectangle represents the field of the image on the sensor, within which the illuminated spot 31 on the substrate is imaged into a corresponding circular area 41. Within this, rectangular areas 42-45 represent the images of the periodic structures 32 to 35. If the periodic structures are located in product areas, product features may also be visible in the periphery of this image field. Processor and controller PU processes these images using pattern recognition to identify the separate images 42 to 45 of periodic structures 32 to 35. In this way, the images do not have to be aligned very precisely at a specific location within the sensor frame, which greatly improves throughput of the measuring apparatus as a whole.

Once the separate images of the periodic structures have been identified, the intensities of those individual images can be measured, e.g., by averaging or summing selected pixel intensity values within the identified areas. Intensities and/or other properties of the images can be compared with one another. These results can be combined to measure different parameters of the lithographic process. Overlay performance is an example of such a parameter.

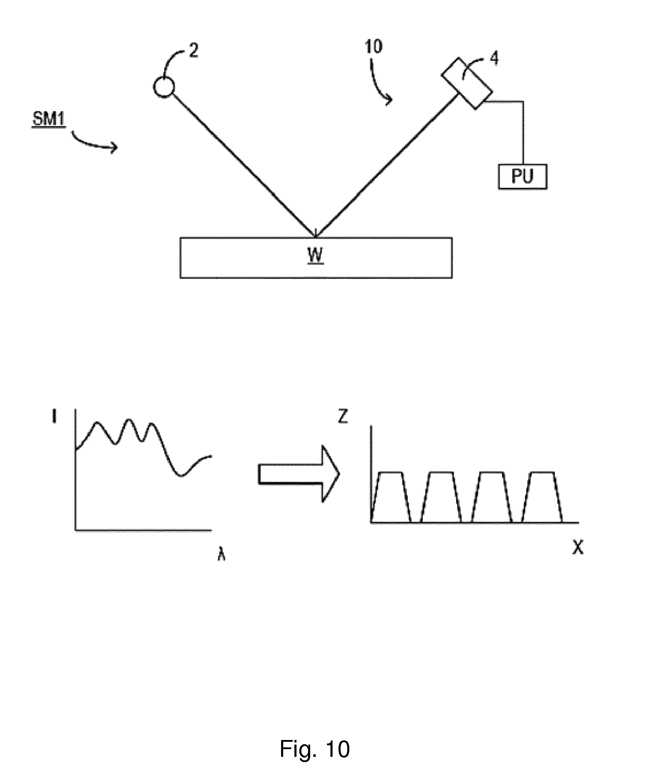

Figure 10 depicts an example inspection apparatus (e.g., a scatterometer). It comprises a broadband (white light) radiation projector 2 which projects radiation onto a substrate W. The redirected radiation is passed to a spectrometer detector 4, which measures a spectrum 10 (intensity as a function of wavelength) of the specular reflected radiation, as shown, e.g., in the graph in the lower left. From this data, the structure or profile giving rise to the detected spectrum may be reconstructed by processor PU, e.g. by Rigorous Coupled Wave Analysis and non-linear regression or by comparison with a library of simulated spectra as shown at the bottom right of Figure 10. In general, for the reconstruction the general form of the structure is known and some variables are assumed from knowledge of the process by which the structure was made, leaving only a few variables of the structure to be determined from the measured data. Such an inspection apparatus may be configured as a normal-incidence inspection apparatus or an oblique-incidence inspection apparatus.

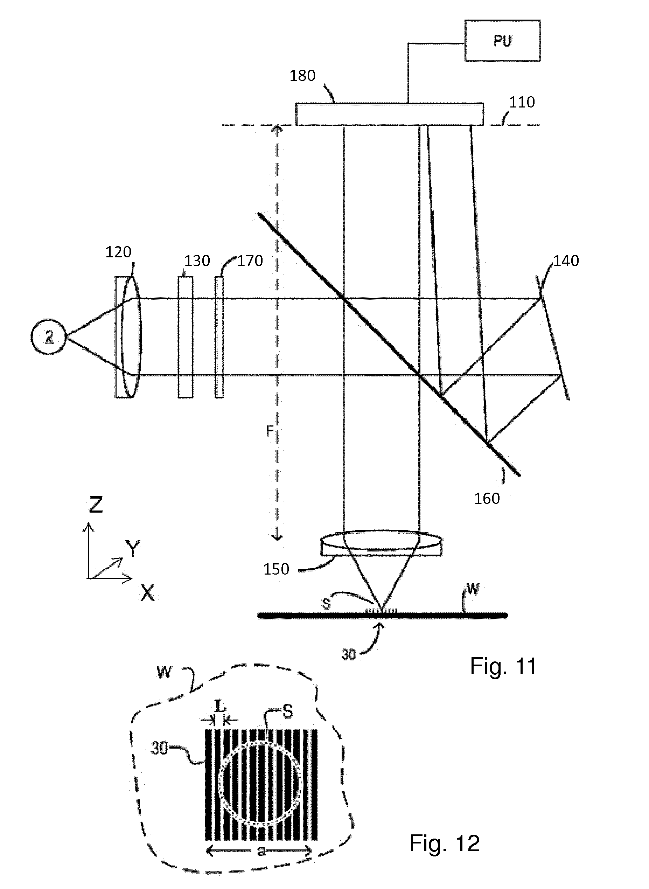

Another inspection apparatus that may be used is shown in Figure 11. In this device, the radiation emitted by radiation source 2 is collimated using lens system 120 and transmitted through interference filter 130 and polarizer 170, reflected by partially reflecting surface 160 and is focused into a spot S on substrate W via an objective lens 150, which has a high numerical aperture (NA), desirably at least 0.9 or at least 0.95. An immersion inspection apparatus (using a relatively high refractive index fluid such as water) may even have a numerical aperture over 1.

As in the lithographic apparatus LA, one or more substrate tables may be provided to hold the substrate W during measurement operations. The substrate tables may be similar or identical in form to the substrate table WT of Figure 1. In an example where the inspection apparatus is integrated with the lithographic apparatus, they may even be the same substrate table. Coarse and fine positioners may be provided to a second positioner PW configured to accurately position the substrate in relation to a measurement optical system. Various sensors and actuators are provided for example to acquire the position of a target of interest, and to bring it into position under the objective lens 150. Typically many measurements will be made on targets at different locations across the substrate W. The substrate support can be moved in X and Y directions to acquire different targets, and in the Z direction to obtain a desired location of the target relative to the focus of the optical system. It is convenient to think and describe operations as if the objective lens is being brought to different locations relative to the substrate, when, for example, in practice the optical system may remain substantially stationary (typically in the X and Y directions, but perhaps also in the Z direction) and only the substrate moves. Provided the relative position of the substrate and the optical system is correct, it does not matter in principle which one of those is moving in the real world, or if both are moving, or a combination of a part of the optical system is moving (e.g., in the Z and/or tilt direction) with the remainder of the optical system being stationary and the substrate is moving (e.g., in the X and Y directions, but also optionally in the Z and/or tilt direction).

The radiation redirected by the substrate W then passes through partially reflecting surface 160 into a detector 180 in order to have the spectrum detected. The detector 180 may be located at a back-projected focal plane 110 (i.e., at the focal length of the lens system 150) or the plane 110 may be re-imaged with auxiliary optics (not shown) onto the detector 180. The detector may be a two-dimensional detector so that a two-dimensional angular scatter spectrum of a substrate target 30 can be measured. The detector 180 may be, for example, an array of CCD or CMOS sensors, and may use an integration time of, for example, 40 milliseconds per frame.

A reference beam may be used, for example, to measure the intensity of the incident radiation. To do this, when the radiation beam is incident on the partially reflecting surface 160 part of it is transmitted through the partially reflecting surface 160 as a reference beam towards a reference mirror 140. The reference beam is then projected onto a different part of the same detector 180 or alternatively on to a different detector (not shown).

One or more interference filters 130 are available to select a wavelength of interest in the range of, say, 405 - 790 nm or even lower, such as 200 - 300 nm. The interference filter may be tunable rather than comprising a set of different filters. A grating could be used instead of an interference filter. An aperture stop or spatial light modulator (not shown) may be provided in the illumination path to control the range of angle of incidence of radiation on the target.

The detector 180 may measure the intensity of redirected radiation at a single wavelength (or narrow wavelength range), the intensity separately at multiple wavelengths or integrated over a wavelength range. Furthermore, the detector may separately measure the intensity of transverse magnetic-and transverse electric-polarized radiation and/or the phase difference between the transverse magnetic-and transverse electric-polarized radiation.

The target 30 on substrate W may be a 1-D grating, which is printed such that after development, the bars are formed of solid resist lines. The target 30 may be a 2-D grating, which is printed such that after development, the grating is formed of solid resist pillars or vias in the resist. The bars, pillars or vias may be etched into or on the substrate (e.g., into one or more layers on the substrate). The pattern (e.g., of bars, pillars or vias) is sensitive to change in processing in the patterning process (e.g., optical aberration in the lithographic projection apparatus (particularly the projection system PS), focus change, dose change, etc.) and will manifest in a variation in the printed grating. Accordingly, the measured data of the printed grating is used to reconstruct the grating. One or more parameters of the 1-D grating, such as line width and/or shape, or one or more parameters of the 2-D grating, such as pillar or via width or length or shape, may be input to the reconstruction process, performed by processor PU, from knowledge of the printing step and/or other inspection processes.

In addition to measurement of a parameter by reconstruction, angle resolved scatterometry is useful in the measurement of asymmetry of features in product and/or resist patterns. A particular application of asymmetry measurement is for the measurement of overlay, where the target 30 comprises one set of periodic features superimposed on another. The concepts of asymmetry measurement using the instrument of Figure 10 or Figure 11 are described, for example, in U.S. patent application publication US2006-066855, which is incorporated herein in its entirety. Simply stated, while the positions of the diffraction orders in the diffraction spectrum of the target are determined only by the periodicity of the target, asymmetry in the diffraction spectrum is indicative of asymmetry in the individual features which make up the target. In the instrument of Figure 11, where detector 180 may be an image sensor, such asymmetry in the diffraction orders appears directly as asymmetry in the pupil image recorded by detector 180. This asymmetry can be measured by digital image processing in unit PU, and calibrated against known values of overlay.

Figure 12 illustrates a plan view of a typical target 30, and the extent of illumination spot S in the apparatus of Figure 11. To obtain a diffraction spectrum that is free of interference from surrounding structures, the target 30, in an embodiment, is a periodic structure (e.g., grating) larger than the width (e.g., diameter) of the illumination spot S. The width of spot S may be smaller than the width and length of the target. The target in other words is 'underfilled' by the illumination, and the diffraction signal is essentially free from any signals from product features and the like outside the target itself. The illumination arrangement 2, 120, 130, 170 may be configured to provide illumination of a uniform intensity across a back focal plane of objective 150. Alternatively, by, e.g., including an aperture in the illumination path, illumination may be restricted to on axis or off axis directions.

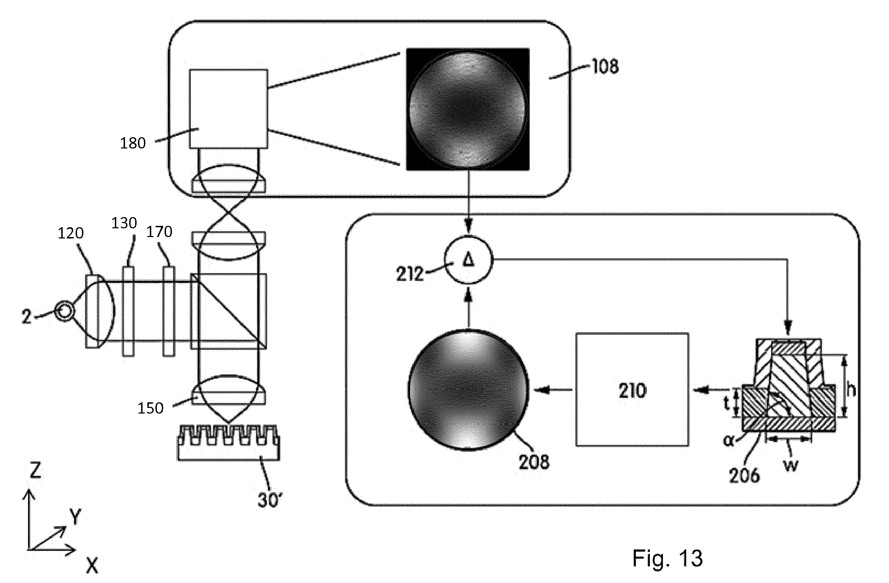

Figure 13 schematically depicts an example process of the determination of the value of one or more variables of interest of a target pattern 30' based on measurement data obtained using metrology. Radiation detected by the detector 180 provides a measured radiation distribution 108 for target 30'.

For a given target 30', a radiation distribution 208 can be computed / simulated from a parameterized model 206 using, for example, a numerical Maxwell solver 210. The parameterized model 206 shows example layers of various materials making up, and associated with, the target. The parameterized model 206 may include one or more of variables for the features and layers of the portion of the target under consideration, which may be varied and derived. As shown in Figure 13, the one or more of the variables may include the thickness $t$ of one or more layers, a width w (e.g., CD) of one or more features, a height h of one or more features, and/or a sidewall angle $\alpha$ of one or more features. Although not shown, the one or more of the variables may further include, but is not limited to, the refractive index (e.g., a real or complex refractive index, refractive index tensor, etc.) of one or more of the layers, the extinction coefficient of one or more layers, the absorption of one or more layers, resist loss during development, a footing of one or more features, and/or line edge roughness of one or more features. The initial values of the variables may be those expected for the target being measured. The measured radiation distribution 108 is then compared at 212 to the computed radiation distribution 208 to determine the difference between the two. If there is a difference, the values of one or more of the variables of the parameterized model 206 may be varied, a new computed radiation distribution 208 calculated and compared against the measured radiation distribution 108 until there is sufficient match between the measured radiation distribution 108 and the computed radiation distribution 208. At that point, the values of the variables of the parameterized model 206 provide a good or best match of the geometry of the actual target 30'. In an embodiment, there is sufficient match when a difference between the measured radiation distribution 108 and the computed radiation distribution 208 is within a tolerance threshold.

The measurement accuracy and/or sensitivity of the target may vary with respect to one or more attributes of the beam of radiation provided onto the target, for example, the wavelength of the radiation beam, the polarization of the radiation beam, and/or the intensity distribution (i.e., angular or spatial intensity distribution) of the radiation beam. In an embodiment, the wavelength range of the radiation beam is limited to one or more wavelengths selected from a range (e.g., selected from the range of about 400 nm to 900 nm). Further, a selection of different polarizations of the radiation beam may be provided and various illumination shapes can be provided using, for example, a plurality of different apertures.

In order to monitor the patterning process (e.g., a device manufacturing process) that includes at least one patterning step (e.g., an optical lithography step), the patterned substrate is inspected and one or more parameters of the patterned substrate are measured. The one or more parameters may include, for example, overlay error between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberrations of an optical lithography step, etc. This measurement may be performed on a target of the product substrate itself and/or on a dedicated metrology target provided on the substrate. There are various techniques for making measurements of the structures formed in the patterning process, including the use of a scanning electron microscope, image-based measurement or inspection tools and/or various specialized tools. As discussed above, a fast and non-invasive form of specialized metrology and/or inspection tool is one in which a beam of radiation is directed onto a target on the surface of the substrate and properties of the scattered (diffracted/reflected) beam are measured. By comparing one or more properties of the beam before and after it has been scattered by the substrate, one or more properties of the substrate can be determined. This may be termed diffraction-based metrology or inspection. One such application of this diffraction-based metrology or inspection is in the measurement of feature asymmetry within a periodic target. This can be used as a measure of overlay error, for example, but other applications are also known. For example, asymmetry can be measured by comparing opposite parts of the diffraction spectrum (for example, comparing the -1st and +1st orders in the diffraction spectrum of a periodic grating). This can be done simply as is described, for example, in U.S. patent application publication US2006-066855, which is incorporated herein in its entirety by reference.

Significant aspects to enabling a patterning process include developing the process itself, setting it up for monitoring and control and then actually monitoring and controlling the process itself. Assuming a configuration of the fundamentals of the patterning process, such as the patterning device pattern(s), the resist type(s), post-lithography process steps (such as the development, etch, etc.), it is desirable to setup the apparatus in the patterning process for transferring the pattern onto the substrates, develop one or more metrology targets to monitor the process, setup up a metrology process to measure the metrology targets and then implement a process of monitoring and/or controlling the process based on measurements.

An etch tool's performance can be monitored using a blanket film test substrate. The blanket film test substrate comprises substrate layer (e.g., a bare silicon wafer) with a flat, smooth, non-patterned etchable layer provided thereon. The etchable layer of the blanket film test substrate is etched by the etch tool to determine the bulk etch rate of the etch tool, specifically a change in thickness of the etchable layer due to the etching by the etch tool over a certain period of time is evaluated to arrive at the etch rate. Accordingly, the etch tool may be adjusted based on the determined etch rate.

So, in an embodiment, there is provided a monitoring and/or control system that monitors and/or controls an etch tool based on a characteristic determined from a monitor substrate in addition, or alternatively, to the etch rate of the etch tool.

In an embodiment, there is provided a monitoring and/or control system that monitors and/or controls the performance of a process tool (e.g., an etch tool) upstream or downstream of a lithography tool using a patterned monitor substrate. The blanket film test substrate described above may not accurately monitor and/or control such a process tool since it doesn't have a pattern.

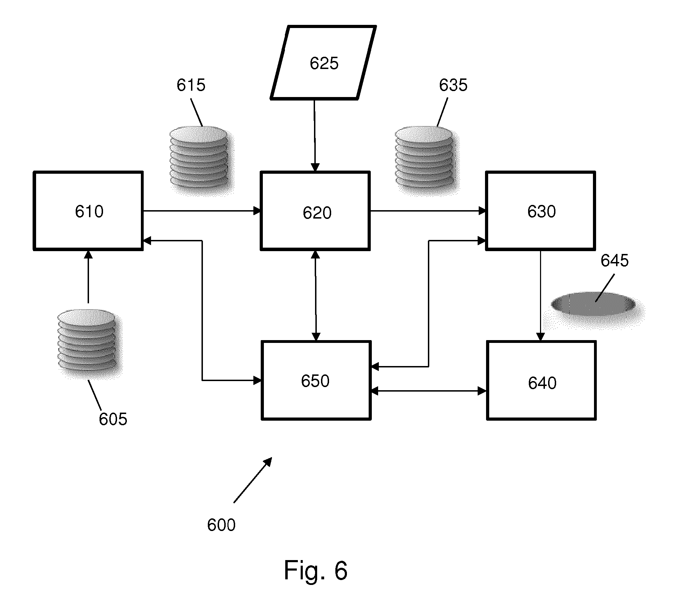

Referring to Figure 6, an example process apparatus baseliner system 600 is schematically shown in an example manufacturing environment. The manufacturing environment comprises a pre-lithography process tool 610, a lithographic system 620, a post-lithography process tool 630, and a metrology apparatus 640. In an embodiment, the pre-lithography process tool 610 comprises a track (such a resist application component of the track), a deposition tool, etc. In an embodiment, the post-lithography process tool 630 comprises a track (such as a development component of the track and/or a bake plate component of the track), an etch tool, a deposition tool, etc. The deposition tool may be a chemical vapor deposition (CVD) and/or physical vapor deposition (PVD) tool. The etch tool may be an atomic layer etch (ALE) tool.

As will be appreciated, the manufacturing environment need not have all the apparatus depicted. Further, one or more of the apparatuses may be combined into one. For example, the metrology apparatus 640 may be part of the pre-lithography process tool 610, the lithographic system 620, and/or the post-lithography process tool 630.

The process apparatus baseliner system 600 comprises a software application 650. In an embodiment, the process apparatus baseliner system 600 can use an existing metrology apparatus 640 or comprises a metrology apparatus 640. Where, for example, the process apparatus baseliner system 600 comprises a metrology apparatus 640, the software application 650 may be provided with the metrology apparatus 640 (e.g., in a computer associated with the metrology apparatus 640). One or more selected from: the pre-lithography process tool 610, the lithographic system 620, the post-lithography process tool 630, and/or the metrology apparatus 640 are in communication with the software application 650 so that results, designs, data, etc. of the applicable pre-lithography process tool 610, lithographic system 620, post-lithography process tool 630, and/or metrology apparatus 640 may be stored and analyzed by the software application 650 at the same time or different times.

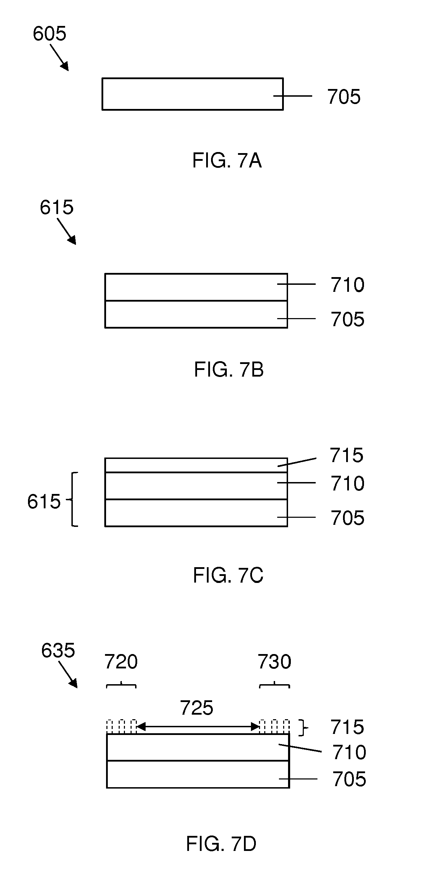

Referring to Figures 7A-7D, an embodiment of a monitor substrate 605, 615, 635 for use with the process apparatus baseliner system 600 is depicted in a side view cross-section. In plan, the monitor substrate may have a same shape as a conventional substrate (e.g., circular disc shaped) and may have a comparable cross-wise dimension (e.g., about 200 mm, about 300 mm or about 450 mm) as a conventional substrate. As schematically shown in Figure 7A, the monitor substrate 605 includes a substrate layer 705 (e.g., a layer of bare silicon). In addition, as schematically shown in Figure 7B, the monitor substrate 615 includes the substrate layer 705 and an etchable layer 710 (e.g., a deposition layer) on the substrate layer 705. The etchable layer 710 may be a layer of one or more suitable materials, e.g., silicon oxide, silicon nitride, etc. In an embodiment, a pre-lithography process tool 610 may be configured to apply the etchable layer to a substrate layer 705 of one or more monitor substrates 605, for example on each of a plurality of substrate layers to form a group of monitor substrates 615. In an embodiment, the pre-lithography process tool 610 to provide the etchable layer 710 is a deposition tool to apply a deposition layer as the etchable layer 710 by means of, for example, atomic layer deposition (ALD), chemical vapor deposition (CVD) or physical vapor deposition (PVD).

As schematically shown in Figure 7C, a resist layer 715 (e.g., a photoresist) may be provided on the etchable layer 710 of the monitor substrate 615. In an embodiment, a pre-lithography process tool 610 may be configured to apply the resist layer 715 to the substrate layer 705 of one or more monitor substrates 605, for example on each of a plurality of etchable layers to form a group of monitor substrates 615. In an embodiment, the pre-lithography process tool 610 to provide the resist layer 715 is a resist coating component of a track.

Referring to Figure 7D, the monitor substrate 635 includes the substrate layer 705 (e.g., a layer of bare silicon) and the etchable layer 710. Furthermore, the monitor substrate 635 includes one or more patterning regions 720, 730. In an embodiment, the monitor substrate 635 includes the resist layer 715 and the resist layer 715 includes the one or more patterning regions 720, 730. An embodiment of how the one or more patterning regions 720, 730 are provided to the resist layer 715 is described below. In an embodiment, the etchable layer 710 comprises the one or more patterning regions 720, 730 therein. For example, the one or more patterning regions 720, 730 may be provided by patterning a resist using patterning device 625 and using the patterned resist to etch the one or more patterning regions 720, 730 into the etchable layer 710.

Optionally, the resist layer 715 includes a region 725 with, e.g., a thickness of zero such that a blank region of the etchable layer 710 beneath is exposed. The region 725 has a sufficient size in a dimension parallel to a direction of elongation of the substrate layer to enable a bulk etch rate of an etch tool to be determined during an etching of the etchable layer. In another embodiment, the region 725 has a dimension of at least 5 microns in the direction parallel a direction of elongation of the substrate layer. In an embodiment, the region 725 has a dimension of at least 1 millimeter in a direction parallel to a direction of elongation of the substrate layer 705. In an embodiment, the region 725 has a dimension of at least 10 mm in the direction parallel a direction of elongation of the substrate layer. More details about the region 725 and/or the etch rate measurement will be discussed in greater detail below. As shown in the embodiment of Figure 7D, the resist layer 715 includes two patterned regions 720, 730, with the region 725 therebetween. However, the region 725 need not be between two patterned regions 720, 730. Further, the patterned regions 720, 730 may be located around the center of the monitor substrate 635; the patterned regions 720, 730 need not continuously extend around the center.

Each of the patterned regions 720, 730 may have one or more patterns transferred from the patterning device 625 as described above. In an embodiment, the one or more patterns comprise a periodic structure (e.g., a grating). In an embodiment, the one or more patterns comprise features corresponding to a functional device. In an embodiment, the one or more patterns comprise features corresponding to a metrology target used in measurements for functional device patterning.

In an embodiment, the one or more patterns are critical patterns with CD relate to the functional device CD, e.g., 10 nm for a 10 nm node. In an embodiment, the one or more patterns include different pitches. For example, a dense pitch and a sparse pitch. Accordingly, in an embodiment, a difference in CD between the dense and sparse pitches is monitored (sometime referred to as iso-dense bias). In an embodiment, a litho-etch bias is monitored. Litho-etch bias is the difference between the post development CD and the post etch CD. In an embodiment, the widths of features of a pattern in the patterned regions 720, 730, the spacing between adjacent features of a pattern in the patterned regions 720, 730 and/or the pitch of a pattern in the patterned regions 720, 730 may range from a few nanometers to hundreds of nanometers.

In an embodiment, the one or more patterns are, or are related to, an overlay or alignment metrology target (e.g., a periodic structure such as a grating) used in measurement for functional device patterning. In an embodiment, the placement of one or features is monitored. In an embodiment, sidewall asymmetry (e.g., difference between the angle of one side wall of a feature to the angle of another side wall of the feature) is monitored. These metrology targets typically have larger CD and pitch than functional device type patterns. In an embodiment, the widths of features of a pattern in the patterned regions 720, 730, the spacing between adjacent features of a pattern in the patterned regions 720, 730 and/or the pitch of a pattern in the patterned regions 720, 730 may range from a few hundred nanometers to tens of microns. In an embodiment, a wide CD (e.g., in the range of microns) may be sub-segmented to dimensions similar to that of functional device pattern features.

The resist layer 715 may have any number and/or size of patterned regions (but at least one). For example, the resist layer 715 may have one patterned region, two patterned regions, three patterned regions, etc. In an embodiment, the number and/or size of patterned regions are constrained such that the region 725 has a sufficient size to enable the etch rate of the etch tool to be determined.

In an embodiment, the lithographic system 620 is configured to produce the one or more patterns in the layer of resist 715 applied on one or more monitor substrates 615 to form one or more patterned monitor substrates 635 (e.g., a group of patterned monitor substrate 635). The lithographic system 620 may include an optical lithographic apparatus such as described in respect of Figure 1, a nanoimprint lithography tool, etc. For example, an optical lithographic apparatus of the lithographic system 620 can expose the resist layer 715 of one or more monitor substrates 615 to transfer a pattern from a patterning device 625 to the resist layer 715 on the one or more monitor substrates 615 to create, for example a plurality of patterned monitor substrates 635. The patterning device 625 may be used to produce a pattern of a functional device on the substrate 615 or produce a pattern design for metrology purposes only. For example, the patterning device 625 may be used to produce a periodic structure, such as a line-and-space grating. In an embodiment, after the patterning by the lithographic system 620, the post-lithography process tool 630 may be used to develop (i.e., remove) portions of the resist to form a pattern comprises one or more recesses in the resist 7715 of the substrate 635. In an embodiment, a post-lithography process tool 630 in the form of a track is used to develop the resist after the pattern transfer of the lithographic system 620.

In an embodiment, the lithographic system 620 is monitored and/or controlled by a lithography baseliner as described above using the monitor substrate 635 having one or more patterning regions 720, 730. For example, one or more characteristics (e.g., critical dimension) of the patterned substrate 635 may be measured. If the measured value of the one or more characteristics varies from a target value of the one or more characteristics (e.g., outside of a threshold range), the lithography baseliner may adjust one or more variables (e.g., dose, focus, etc.) of the lithographic system 620. In this manner, the lithographic system 620 may be monitored and/or controlled for drift from a baseline of operation.

In an embodiment, the monitor substrate 635 having the one or more patterning regions 720, 730 is processed by a pre-lithography process tool 610 and/or by a post-lithography process tool 630 in accordance with the process apparatus baseliner system 600. In an embodiment, the pre-lithography process tool 610 and/or the post-lithography process tool 630 is configured to process each of the patterned monitor substrates 635 to form a group of processed monitor substrates 645.

In an embodiment, the monitor substrate 635 is processed by a post-lithography process tool 630. In an embodiment, the post-lithography tool 630 comprises an etch tool configured to etch the etchable layer 710 of the patterned substrate 635 and accordingly transfer the one or more patterns of the etchable layer 710 further into the etchable layer 710 or to transfer the one or more patterns in the resist layer 715 to the etchable layer 710, to form the processed substrate 645.

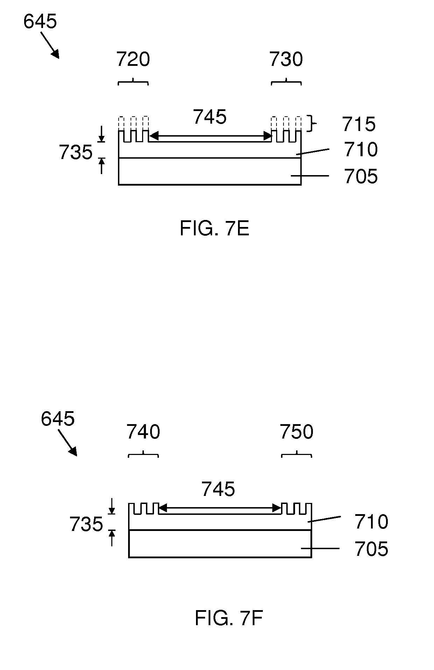

Figure 7E schematically shows a side view cross section of the processed substrate 645 after etching. As shown, a portion of the etchable layer 710 that is not covered by the resist layer 715 (specifically, the patterned regions 720, 730 of the resist layer 715) is etched because the resist resists at least in part etching.

In an embodiment, an unpatterned blank region 745 is formed in the etchable layer 710. The blank region 745 may have a similar dimension as the region 725 in the resist layer 715, in the direction parallel to a direction of elongation of the substrate layer. In an embodiment, the blank region 745 in the etchable layer 710 may have a sufficient size to enable a bulk etch rate of the etch tool to be measured. For example, the blank region 745 in the etchable layer 710 may have a dimension of at least 5 microns in the direction parallel to a direction of elongation of the substrate layer 705. In an embodiment, the blank region 745 in the etchable layer 710 may have a dimension of at least 1 mm in the direction parallel to a direction of elongation of the substrate layer 705. In an embodiment, the blank region may have a dimension of at least 10 mm in the direction parallel to a direction of elongation of the substrate layer 705. In an embodiment, the metrology apparatus 640 may be configured to monitor the thickness of the blank region 745 in the etchable layer 710; in an embodiment, the etch tool includes a metrology module configured to monitor the thickness 735 of the blank region 745 in the etchable layer 710 to derive the etch rate. To arrive at the etch rate, a first thickness of the blank region 745 is measured at a first time before or during the etching process of the etchable layer 710. A second thickness of the blank region 745 is measured at a second time during or after the etching process of the etchable layer 710. The etch rate of the etch tool may be determined by dividing a difference between the first thickness and the second thickness by a length of time between the first time and the second time during which the etchable layer 710 is being processed by the etch tool. In an embodiment, the blank region 745 of the etchable layer may have a post-etch thickness of zero. However, in other embodiments, the etchable layer may still have remaining thickness to it, which is the case in the embodiments shown in Figures 7E-7G. As shown in Figure 7F, where needed, the resist layer 715 is removed from the processed substrate 645.

Referring to Figure 7F, after the etching is completed, the processed monitor substrate 645 includes merely the substrate layer 705 and the etchable layer 710. The etchable layer 710 includes one or more patterned regions 740, 750. In an embodiment, the etchable layer 710 includes the blank region 745. Similar to the one or more patterned regions 720, 730, the etchable layer 710 may have an arbitrary number of patterned regions 740, 750. For example, the etchable layer 710 may have one patterned region, three patterned regions, five patterned regions, eight patterned regions, etc. In an embodiment, the number and/or size of patterned regions 740, 750 are constrained such that the blank region 745 has a sufficient size to enable the etch rate of the etch tool to be determined. Each of the patterned regions 740, 750 may one or more patterns transferred from the patterned regions 720, 730 of the patterned substrate 635. The one or more patterns may be configured to be measured by the metrology apparatus 640. In an embodiment, for functional device like patterns, the widths of features of a pattern in the patterned regions 720, 730, the spacing between adjacent features of a pattern in the patterned regions 720, 730 and/or the pitch of a pattern in the patterned regions 720, 730 may range from a few nanometers to hundreds of nanometers. In an embodiment, for metrology target like patterns, the widths of features of a pattern in the patterned regions 720, 730, the spacing between adjacent features of a pattern in the patterned regions 720, 730 and/or the pitch of a pattern in the patterned regions 720, 730 may range from a few hundred nanometers to tens of microns.

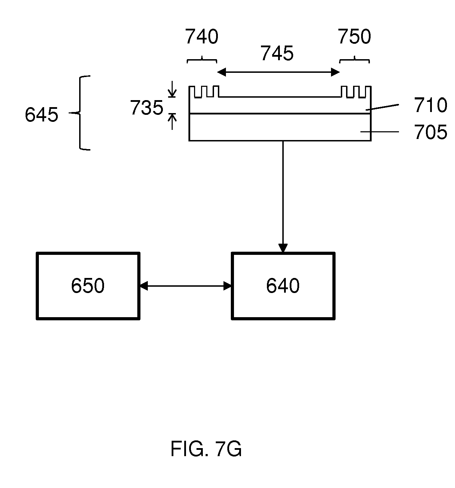

As schematically shown in Figure 7G, the metrology apparatus 640 may be configured to evaluate at least one characteristic of the processed substrate 645. For example, the metrology apparatus 640 may be configured to evaluate at least one characteristic of the patterned region 740, 750 of the processed substrate 645. In an embodiment, the characteristic comprises one or more selected from: critical dimension, overlay, side wall angle (i.e., an angle of a side wall of a pattern feature), bottom surface tilt (i.e., a tilt of a bottom surface of a gap in a pattern), pattern feature height, layer thickness, pattern shift (e.g., in two orthogonal directions), geometric asymmetry (e.g., a difference in side wall angles for a feature) and/or one or more other geometrical parameters of at least one pattern in the patterned region 740 and/or patterned region 750. As noted above, the pattern of the grating is sensitive to one or more non-lithographic processes (e.g., deposition, etching, planarization, etc.) and the presence of such characteristics will manifest themselves in a variation in the printed grating. Thus, the at least one characteristic can be film thickness uniformity, etch rate uniformity, etch slant angle uniformity, and/or planarization dishing.

In an embodiment, the metrology apparatus 640 may be an optical (e.g., diffraction-based) metrology tool that can measure the characteristic. In some examples, the etchable layer 710 may include a plurality of patterned regions (e.g., identical patterned regions) across the substrate. Accordingly, the metrology apparatus 640 may measure the characteristic of the plurality of patterned regions across the processed substrate 645. Thus, in an embodiment, a spatial distribution of the at least one characteristic across the processed substrate 645 is determined. In an embodiment, the metrology apparatus 640 is a level sensor to measure a position of a surface, e.g., a height and/or rotational position of a surface of the processed substrate 645.

The software application 650 may be configured to create modification information using the measurement data (e.g., critical dimension, overlay, side wall angle, bottom surface tilt, pattern shift, geometric asymmetry, etc.) from the metrology apparatus 640. For example, the software application 650 may be configured to determine whether a measured value of at least one characteristic measured by the metrology apparatus 640 meets a target value of the at least one characteristic (which can include a tolerance range). In an embodiment, the software application 650 determines a deviation (e.g., a difference) between the measured value of the at least one characteristic measured by the metrology apparatus 640 and the target value of the at least one characteristic. In an embodiment, the deviation may be a critical dimension error, overlay error, a side wall angle error, a bottom surface tilt error, a pattern shift error, etc. In an embodiment, the software application 650 determines a spatial distribution of whether the measured value of at least one characteristic measured by the metrology apparatus 640 meets the target value of the at least one characteristic across the processed substrate 645.

At step 830, an action can be taken responsive to a determination that a measured value of at least one characteristic measured by the metrology apparatus 640 does not meet a target value of the at least one characteristic (which can include a tolerance range). In an embodiment, the software application 650 can notify a user of such a determination. In an embodiment, the software application 650 is configured to create modification information to modify operation of the post-lithography process tool 630 to, e.g., correct (e.g., eliminate or reduce to within a tolerance range) a deviation between the measured value of the at least one characteristic measured by the metrology apparatus 640 and the target value of the at least one characteristic.

In an embodiment, the modification information may be created to adjust the post-lithography process tool 630 based at least in part on the deviation (e.g., a difference). Specifically, the modification information may be created to adjust one or more variables of the post-lithography process tool 630. For example, when the post-lithography process tool 630 is an etch tool, the modification information may be used to modify one or more etch variables (e.g., etch rate, etch type, etc.) spatially based on the spatial distribution of the deviation or of the measured values of the at least one characteristic. Further, in an embodiment, the bulk etch rate determined using the blank region 745 can be used to apply a global change across the substrate to an etch variable (e.g., a change in etch rate). In an embodiment, the process tool can have a plurality of zones (e.g., 10 or more, 20 or more, 30 or more zones), etc. to provide different control of the applicable process. For example, the etch tool may have a plurality of zones that each provide separate control over an attribute of the etch (e.g., etch rate, etch angle, etc.). So, in an embodiment, the modification information can enable differential control of one or more zones of the process tool.

In an embodiment, the modification information may be created to match the performance of two or more post-lithography process tools 630 or different components of the same post-lithographic tool 630 or of different post-lithography process tools 630. Thus, the target value from which deviation is evaluated is a value of the characteristic for another tool and/or component. For example, when the patterning process tool 630 is the etch tool, a processed substrate 645 may be formed by etching the etchable layer 710 using a first etch chamber of the etch tool, using a second etch chamber of the etch tool, or both. In order to match the performance between the first etch chamber and the second etch chamber, the software application 650 may be configured to determine a deviation between a value of characteristic of a first pattern processed by the first etch chamber and of a second pattern processed by the second etch chamber of the etch tool. The software application 650 may be further configured to create modification information to adjust one or more variables (e.g., the etch rate or etch type) of the first etch chamber and/or of the second etch chamber in order to correct the deviation between the values of the characteristic between the pattern processed by the first etch chamber and the second etch chamber. Thus, in an embodiment, the modification information can cause the spatial distribution of the characteristic for the first etch chamber to match within a tolerance range the spatial distribution of the characteristic for the second etch chamber.

While the discussion has focused on an etch tool, in an embodiment, the post-lithography process tool 630 may be a track (or a component thereof such as a development tool or a bake tool), a deposition tool, a chemical mechanical polishing/planarization (CMP) tool or other post-lithography process tool that changes a physical characteristic of the processed substrate 645. In the case of one or more such tools, the layer 710 need not be etchable and of course, the processing of the substrate need not involve an etching (e.g., where the post-lithography process tool 630 is a development tool or a bake tool). In an embodiment, the process apparatus baseliner system 600 evaluates a pre-lithography process tool 610 (instead of or in addition to a post-lithography process tool 630). The pre-lithography process tool 610 may be a track (or a component thereof such as a resist application tool), a deposition tool or other pre-lithography process tool that changes a physical characteristic of the processed substrate 645. In the case of one or more such tools, the layer 710 need not be etchable and of course, the processing of the substrate need not involve an etching (e.g., where the pre-lithography process tool 610 is a resist application tool).

So, when the evaluated tool is a track, the one or more variables may be one or more track variables, such as a bake temperature (e.g., global change or a spatially distributed change) of a bake tool of the track, and/or a development variable of a development tool of the track. When the evaluated tool is a deposition tool, the one or more variables may be one or more deposition variables (e.g., global or spatial change in rate of deposition, spatial variance of deposition, etc.). When the evaluated tool is a CMP tool, the one or more variables may be one or more planarization variables (e.g., global or spatial change in rate of planarization, spatial variance of planarization, etc.).

In an embodiment, the measured values and/or the modification information can be specific to a particular apparatus, e.g., specific to etch chambers of an etch tools, specific to an etch tool among a plurality of etch tools, etc. Thus, the monitoring and/or control can be specific to tools and/or parts thereof. So, for example, based on what tools and/or parts thereof are being used in a particular patterning process of a functional device, appropriate modification information can be applied to the tool(s) and/or part(s) thereof being used to process one or more substrate in the patterning process.

Further, the deviation in a post-lithography tool can be corrected in another tool, e.g., a pre-lithography process tool or a lithographic system, or vice versa. Thus, the modification information need not be for the tool being evaluated. For example, one or more lithography variables of the lithographic system 620 can be adjusted. In an embodiment, the one or more lithography variables include a dose and/or a focus. As an example, the modification information may be created to adjust one or more modification apparatuses of the lithographic apparatus, e.g., by employing the adjustment mechanism AM to correct for or apply an optical aberration, by employing the adjuster AD to correct or modify an illumination intensity distribution, by employing the positioner PM of the patterning device support structure MT to correct or modify the position of the patterning device support structure MT, by employing the positioner PW of the substrate table WT to correct or modify the position of the substrate table WT, etc.

Thus, in an example of evaluation of a post-lithography process tool 630, modification information may be created to modify one or more variables of a post-lithography process tool 630, and/or one or more process apparatuses upstream or downstream from the post-lithography process tool 630. The one or more process apparatuses may include, e.g., a pre-lithography process tool 610, a lithographic system 620, and/or another post-lithography process tool 630.

In an embodiment, the software application 650 uses one or more mathematical models to determine a deviation in the at least one characteristic correctable by one or more selected from: a pre-lithography process tool 610, a lithographic system 620, and/or a post-lithography process tool 630. The software application 650 may be further configured to provide the modification information that enables configuration of one or more selected from: a pre-lithography process tool 610, a lithographic system 620, and/or a post-lithography process tool 630 to correct (e.g., eliminate or reduce to within a tolerance range) the deviation. In an embodiment, one or more of the mathematical models define a set of basis functions that fit the data once parameterized. In an embodiment, the model specifies a range of modifications that one or more selected from: a pre-lithography process tool 610, a lithographic system 620, and/or a post-lithography process tool 630 can make and determines whether the correctable deviation is within the range. That is, the range may specify an upper limit, a lower limit, and/or both on the amount of modification that a pre-lithography process tool 610, a lithographic system 620, and/or a post-lithography process tool 630 can make. For example, in an embodiment, the correctable deviation $\Delta x$ in an x direction at the coordinate $(x,y)$, can be modeled by:

$$\Delta x = k_1 + k_3 x + k_5 y + k_7 x^2 + k_9 xy + k_{11} y^2 + k_{13} x^3 + k_{15} x^2 y + k_{17} xy^2 + k_{19} y^3 \qquad (1)$$

where $k_1$ is a parameter (that may be constant), and $k_3$, $k_5$, $k_7$, $k_9$, $k_{11}$, $k_{13}$, $k_{15}$, $k_{17}$, and $k_{19}$ are parameters (that may be constant) for the terms x, y, $x^2$, xy, $y^2$, $x^3$, $x^2y$, $xy^2$, and $y^3$, respectively. One or more of $k_1$, $k_3$, $k_5$, $k_7$, $k_9$, $k_{11}$,

k13, k15, k17, and k19 may be zero. Relatedly, in an embodiment, the correctable deviation $\Delta y$ in a y direction at the coordinate (x,y), can be modeled by:

$$\Delta y = k_2 + k_4 y + k_6 x + k_8 y^2 + k_{10} yx + k_{12} x^2 + k_{14} y^3 + k_{16} y^2 x + k_{18} yx^2 + k_{20} x^3 \qquad (2)$$

where $k_2$ is a parameter (that may be constant), and $k_4$, $k_6$, $k_8$, $k_{10}$, $k_{12}$, $k_{14}$, $k_{16}$, $k_{18}$, and $k_{20}$ are parameters (that may be constant) for the terms y, x, $y^2$, yx, $x^2$, $y^3$, $y^2x$, $yx^2$, and $x^3$, respectively. One or more of $k_2$, $k_4$, $k_6$, $k_8$, $k_{10}$, $k_{12}$, $k_{14}$, $k_{16}$, $k_{18}$, and $k_{20}$ may be zero.

In an embodiment, co-optimization of the deviation correction by two or more selected from: a pre-lithography process tool 610, a lithographic system 620, and/or a post-lithography process tool 630 is provided. In an embodiment, one or more mathematical models to determine error correctable by two or more selected from: a pre-lithography process tool 610, a lithographic system 620, and/or a post-lithography process tool 630 are combined to enable the co-optimization.

In an embodiment, the co-optimization is performed separately or on a combined basis for different types of error, such as performed separately or on a combined basis for critical dimension error, overlay error, pattern shift error, etc. In an embodiment, the pre-lithography process tool 610, the lithographic system 620, or the post-lithography process tool 630 may be better able to correct certain types of error and so the error correction is appropriately weighted or apportioned among the suitable different variables of two or more selected from: a pre-lithography process tool 610, a lithographic system 620, and/or a post-lithography process tool 630.

Because, in an embodiment, a same substrate has both the blank regions 725, 745 and patterned regions 720, 730, 740, and 750, the determining of the etch rate of the etch tool (used to etch the etchable layer 710) using the blank region 745, and the measuring of one or more characteristics (and determining an associated deviation thereof) of the patterned region 740, 750, can be performed without needing to use different substrates for those functions. Specifically, a bulk etch rate could be determined using the blank region 745 of the etchable layer 710, while the measurement of the patterned region can be used to determine a deviation of a measured value of characteristic of the patterned region from a target value and accordingly make a correction (e.g., a spatially varying correction).

In an embodiment, the software application 650 is configured to identify one or more pattern targets for application to the substrate 635, 645 and for measurement with a process apparatus baseliner system, and develop a metrology recipe for the one or more targets. A metrology recipe in this context is one or more variables (and one or more associated values) associated with the metrology apparatus 640 itself used to measure the one or more metrology targets and/or with the measurement process, such as one or more wavelengths of the measurement beam, one or more types of polarization of the measurement beam, one or more dose values of the measurement beam, one or more bandwidths of the measurement beam, one or more aperture settings of the inspection apparatus used with the measurement beam, an alignment mark used to locate the measurement beam on the target, an alignment scheme used, a sampling scheme of a plurality of targets, a layout of the targets, a movement scheme to measure the targets and/or points of interest of a target, etc.

In an embodiment, the one or more targets may be designed and qualified for the patterning process. For example, a plurality of target designs may be evaluated to identify the one or more targets that minimize residual variation (systematic and/or random). In an embodiment, a plurality of target designs may be evaluated to identify the one or more targets whose performance match a functional device, e.g., identify a target whose measure of critical dimension, overlay, pattern shift, etc. matches the critical dimension, overlay, pattern shift, etc. of the device. The target may be designed, e.g., for measurement of critical dimension (CD), of overlay, of pattern shift, of side wall angle, of bottom surface tilt, of geometric asymmetry in the target, etc. or any combination selected therefrom.

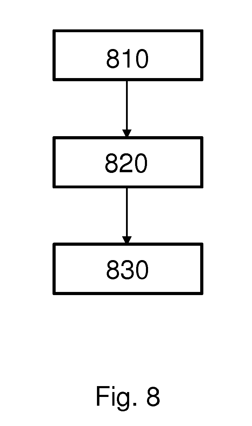

Referring to Figure 8, an example flowchart of a method of adjusting one or more substrate manufacturing variables is depicted. At step 810, a pattern on a substrate (e.g., the processed substrate 645) is evaluated after the substrate has been processed by a process tool (e.g., the post-lithography process tool 630). In an embodiment, the processing of the substrate by a process tool comprises forming at least part of the pattern by etching. In an embodiment, the processing of the substrate by a process tool comprises deposition of layer on at least part of a pattern of the substrate. In an embodiment, the processing of the substrate by a process tool comprises developing at least part of a pattern in resist on the substrate. In an embodiment, the processing of the substrate by a process tool comprises planarization of at least part of a pattern on the substrate. In an embodiment, the processing of the substrate by a process tool comprises baking at least part of a pattern on the substrate.

In an embodiment, the pattern on the processed substrate is evaluated by obtaining a measurement of at least one characteristic of the pattern on the substrate. In an embodiment, the at least one characteristic of the pattern comprises a critical dimension of the pattern, an overlay error of the pattern, a side wall angle of the pattern, a bottom surface tilt of the pattern, a pattern shift of the pattern, a geometric asymmetry of the pattern, etc.

In an embodiment, the substrate comprises a substrate layer (e.g., the substrate layer 705), and a layer (e.g., the etchable layer 710) on the substrate layer and having a patterned region therein or thereon (e.g., the patterned regions 720, 730). The pattern is in the patterned region. In an embodiment, the substrate layer comprises bare silicon. In an embodiment, the layer on the substrate layer comprises a patterned region (e.g., the patterned regions 720, 730) thereon in the form of a patterned resist layer. In an embodiment, the substrate comprises a blank region (e.g., the blank region 745) of the layer on the substrate layer. The blank region is sized to enable an etch rate of an etch tool to be determined. In an embodiment, the blank region has a dimension of at least 1 mm in a direction parallel to a direction of elongation of the substrate layer.

At step 820, it is determined whether a measured value of at least one characteristic measured by the metrology apparatus 640 meets a target value of the at least one characteristic (which can include a tolerance range). For example, it can be determined whether there is an error between the measured pattern and a target pattern. In an embodiment, the target value can be an earlier value of the measured at least one characteristic. In an embodiment, the target value can be a statistic (e.g., mean, standard deviation, etc.) related to the at least one characteristic (e.g., previously measured values of the at least one characteristic, a user specified value of the statistic, etc.). In an embodiment, a deviation (e.g., a difference) between the measured value of the at least one characteristic measured by the metrology apparatus 640 and the target value of the at least one characteristic is determined. In an embodiment, the deviation may be a critical dimension error, overlay error, a side wall angle error, a bottom surface tilt error, a pattern shift error, etc. In an embodiment, a spatial distribution of the measured values of the at least one characteristic or of whether the measured value of at least one characteristic meets the target value of the at least one characteristic, across the processed substrate is determined. In an embodiment, a spatial distribution of the error is determined across the substrate.

At step 830, an action can be taken responsive to a determination that a measured value of at least one characteristic does not meet a target value of the at least one characteristic (which can include a tolerance range). In an embodiment, a user can be notified of such a determination. In an embodiment, modification information is created, by a hardware computer system, to adjust the process tool (e.g., the post-lithography process tool 630) and/or adjust one or more processing apparatuses upstream or downstream from the process tool. In an embodiment, the modification information is generated based at least in part on a deviation (e.g., a difference) between the measured value of the at least one characteristic and the target value of the at least one characteristic. In an embodiment, the process tool is an etch tool, a track tool, a CMP tool, or a deposition tool. In an embodiment, the one or more processing apparatuses upstream or downstream from the process tool are one or more process apparatuses selected from: a deposition tool, a track tool, a CMP tool, an etch tool and/or a lithographic apparatus.

In an embodiment, steps 810-830 can be repeated over time to enable monitoring and/or control of a process tool. For example, monitor substrates 645 can be run through the process tool between processing of production substrates to determine the performance of the process tool (e.g., to identify drift of the process tool) and take appropriate action (e.g., generate modification information, notify a user, etc.). Similarly, performance between different process tools and/or different parts of a same process tool can be evaluated. For example, monitor substrates 645 can be run through the different process tools and/or different parts of a same process tool between processing of production substrates to determine the performance of the different process tools and/or different parts of a same process tool (e.g., to identify drift of one process tool relative to another process tool, identify drift one part of a process tool relative to another part of the same process tool, etc.) and take appropriate action (e.g., generate modification information, notify a user, etc.).

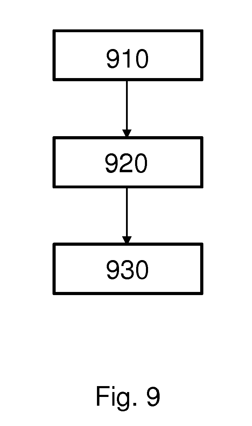

Referring to Figure 9, an example flowchart of a further method of adjusting one or more substrate manufacturing variables is depicted. At step 910, a patterned substrate (e.g., the patterned substrate 635) is provided. The patterned substrate includes a substrate layer (e.g., the substrate layer 705) and an etchable layer (e.g., the etchable layer 710) on the substrate layer. In an embodiment, the patterned substrate includes a resist layer (e.g., the resist layer 715) on the etchable layer. The substrate layer may include bare silicon. In an embodiment, the etchable layer may include silicon dioxide, silicon nitride, or any other suitable material. The etchable layer has at least one first patterned region (e.g., the patterned regions 720, 730 of the patterned substrate 635) thereon or therein, and a blank region (e.g., the blank region 725 of the patterned substrate 635). In an embodiment, the blank region is exposed to enable direct etching by an etch tool. In an embodiment, the at least one first patterned region comprises a patterned portion of a resist layer (e.g., the resist layer 715) on the etchable layer. Where there is a resist layer, the resist layer may have an open region to enable the blank region of the etchable layer to be exposed. The blank region is of sufficient size to enable an etch rate of an etch tool to be determined. In an embodiment, the blank region has a dimension of at least 1 mm in a direction parallel to a direction of elongation of the substrate layer.

At step 920, the etchable layer is etched with an etch tool. In an embodiment, after etching, the etchable layer has at least one second patterned region (e.g., the patterned regions 740, 750 of the processed substrate 645) therein. In an embodiment, after etching, the blank region has been etched to form a reduced thickness blank region (e.g., the blank region 745 of the processed substrate 645).

At step 930, an etch rate of the etch tool is measured, e.g., at the blank region of the etchable layer. Specifically, a first thickness of the blank region is measured at a first time before or during the etching. A second thickness of the blank region is measured at a second time during or after the etching. The etch rate of the etch tool can then be determined based on a difference between the first thickness and the second thickness and a length of time between the first time and the second time when the etchable layer is being processed by the etch tool.

In an embodiment, there is provided a substrate, comprising: a substrate layer; and an etchable layer on the substrate layer, the etchable layer comprising a patterned region thereon or therein and comprising a blank region of sufficient size to enable an etch rate of an etch tool for etching the blank region to be determined.

In an embodiment, the substrate further comprises a resist layer on the etchable layer, the resist layer comprising the patterned region. In an embodiment, the patterned region comprises a pattern to be transferred from the resist layer to the etchable layer using the etch tool. In an embodiment, the resist layer comprises an open region to expose the blank region to an etchant of the etch tool, the open region being of sufficient size to enable the etch rate of the etch tool for etching the blank region to be determined. In an embodiment, the blank region has a dimension of at least 1 millimeter in a direction parallel to a direction of elongation of the substrate layer. In an embodiment, the blank region has a post-etch thickness of zero. In an embodiment, the substrate layer comprises bare silicon. In an embodiment, the patterned region comprises a pattern to be measured by a metrology apparatus.

In an embodiment, there is provided a method, comprising: evaluating a pattern on a substrate after the substrate has been processed by a process tool upstream or downstream from a lithography tool, to determine a value of a characteristic of the evaluated pattern; determining whether the value of the characteristic of the evaluated pattern meets a target value of the characteristic; and responsive to a determination that the value of the characteristic of the evaluated pattern does not meet the target value of the characteristic, creating and outputting, by a hardware computer system and based at least in part on the determination, information regarding the process tool.

In an embodiment, the determining comprises determining a deviation between the value of the characteristic of the evaluated pattern and the target value of the characteristic and the creating and outputting comprises creating, based at least in part on the deviation, modification information to adjust the process tool and/or another process apparatus upstream or downstream from the process tool. In an embodiment, the process apparatus upstream or downstream from the process tool comprises one or more selected from: a deposition tool, a track tool, an etch tool, a chemical mechanical planarization (CMP) tool, and/or the lithography tool. In an embodiment, the modification information is used to modify a variable of the process tool and/or another process apparatus upstream or downstream from the process tool, and wherein the variable comprises a deposition variable of a deposition tool, a track variable of a track, a lithography variable of a lithographic apparatus, an etch variable of an etch tool, and/or a planarization variable of a CMP tool. In an embodiment, the variable comprises the track variable of the track, the track variable comprising a bake temperature of a bake tool of the track or a development variable of a development tool of the track. In an embodiment, the variable comprises the lithography variable of the lithographic apparatus, the lithography variable comprising a dose or a focus. In an embodiment, the variable comprises the etch variable of the etch tool, the etch variable comprising an etch type of the etch tool or an etch rate of the etch tool. In an embodiment, the determining comprises determining a spatial distribution of the value of the characteristic of the evaluated pattern or of a deviation between the value of the characteristic of the evaluated pattern and the target value of the characteristic, across the substrate. In an embodiment, the creating modification information comprises creating modification to adjust a variable of a first component of the process tool separately from a second component of the process tool. In an embodiment, the process tool is an etch tool, the pattern having been processed by a first etch chamber of the etch tool, and the target value being for a second etch chamber of the etch tool. In an embodiment, the process tool is an etch tool, a track, a chemical mechanical planarization (CMP) tool, or a deposition tool. In an embodiment, the process tool comprises an etch tool. In an embodiment, the substrate comprises a substrate layer and an etchable layer, and wherein the etchable layer comprises a patterned region therein or thereon and a blank region, the blank region sized to enable an etch rate of the etch tool to be determined. In an embodiment, the method further comprises etching at least blank region of the etchable layer with an etch tool; and determining, using the etched blank region, the etch rate of the etch tool. In an embodiment, the determining the etch rate of the etch tool comprises: measuring a first thickness of the blank region at a first time; measuring a second thickness of the blank region at a second time; and determining the etch rate of the etch tool based on a difference between the first thickness and the second thickness and a length of time between the first time and the second time when the substrate is being processed by the etch tool. In an embodiment, the blank region has a dimension of at least 1 millimeter in a direction parallel to the substrate layer. In an embodiment, the method comprises creating, based at least in part on the determined etch rate, modification information to adjust the process tool. In an embodiment, evaluating the pattern on the substrate comprises obtaining a measurement of the value of the characteristic of the pattern on the substrate. In an embodiment, the characteristic of the pattern comprises one or selected from: critical dimension, overlay, side wall angle, bottom surface tilt, pattern feature height, layer thickness, pattern shift, geometric asymmetry and/or one or more other geometrical parameters.

In an embodiment, there is provided a method, comprising: providing a substrate that includes a substrate layer and an etchable layer on the substrate layer, the etchable layer having a first patterned region thereon or therein and a blank region; etching, with an etch tool, at least part of the patterned region to form a second patterned region in the etchable layer; and evaluating a characteristic of the second patterned region; and creating and outputting, by a hardware computer system, information regarding the etch tool based on the evaluated characteristic.

In an embodiment, the evaluating comprises determining a deviation between a value of the evaluated characteristic of the second patterned region and a target value of the characteristic, and wherein the creating and outputting comprises creating modification information, based on the deviation, to adjust the etch tool and/or adjust a process apparatus upstream or downstream from the etch tool. In an embodiment, the process apparatus upstream or downstream from the etch tool comprises one or more selected from: a deposition tool, another etch tool, a track tool, a chemical mechanical planarization (CMP) tool, and/or a lithography tool. In an embodiment, the modification information is used to modify a variable of the etch tool and/or another process apparatus upstream or downstream from the etch tool, and wherein the variable comprises a deposition variable of a deposition tool, a track variable of a track, a lithography variable of a lithographic apparatus, an etch variable of another etch tool, and/or a planarization variable of a CMP tool. In an embodiment, the variable comprises the track variable of the track, the track variable comprising a bake temperature of a bake tool of the track or a development variable of a development tool of the track. In an embodiment, the variable comprises the lithography variable of the lithographic apparatus, the lithography variable comprising a dose or a focus. In an embodiment, the variable comprises the etch variable of the etch tool, the etch variable comprising an etch type of the etch tool or an etch rate of the etch tool. In an embodiment, the evaluating comprises determining a spatial distribution of the value of the characteristic of the evaluated pattern or of a deviation between the value of the characteristic of the evaluated pattern and a target value of the characteristic, across the substrate. In an embodiment, the creating modification information comprises creating modification to adjust a variable of a first etch chamber of the etch tool separately from a second etch chamber of the etch tool. In an embodiment, the second patterned region is generated by a first etch chamber of the etch tool, and the target value is for a second etch chamber of the etch tool. In an embodiment, the evaluating the characteristic of the second patterned region comprises obtaining a measurement of a value of the characteristic of a pattern in the second patterned region. In an embodiment, the characteristic of the second patterned region comprises one or selected from: critical dimension, overlay, side wall angle, bottom surface tilt, pattern feature height, layer thickness, pattern shift, geometric asymmetry and/or one or more other geometrical parameters. In an embodiment, the blank region has a dimension of at least 1 millimeter in a direction parallel to a direction of elongation of the substrate layer. In an embodiment, the first patterned region comprises a pattern in a resist layer on the etchable layer. In an embodiment, the method further comprises determining an etch rate of the etch tool based on etching of at least part of the blank region of the etchable layer. In an embodiment, the method comprises creating modification information, based at least in part on the etch rate, to adjust the etch tool and/or adjust a process apparatus upstream or downstream from the etch tool. In an embodiment, determining the etch rate comprises: measuring a first thickness of the blank region at a first time; measuring a second thickness of the blank region at a second time; and determining the etch rate of the etch tool based on a difference between the first thickness and the second thickness and a length of time between the first time and the second time when the etchable layer is being processed by the etch tool.

In an embodiment, there is provided a substrate, comprising: a substrate layer; and a deposition layer on the substrate layer, the deposition layer comprising a blank region and a patterned region therein, and the blank region being of sufficient size to enable an etch rate to be determined thereof. In an embodiment, the blank region has a dimension of at least 1 millimeter in a direction parallel to the substrate layer. In an embodiment, the blank region has a post-etch thickness of zero. In an embodiment, the substrate layer comprises bare silicon. In an embodiment, the patterned region comprises a pattern to be measured by a metrology apparatus.

In an embodiment, there is provided a substrate, comprising: a substrate layer; a deposition layer on the substrate layer; and a resist layer on the deposition layer, wherein the resist layer comprises a patterned region and an unpatterned region, the unpatterned region being of sufficient size to enable an etch rate of an etch tool for etching the deposition layer to be determined. In an embodiment, the unpatterned region has a dimension of at least 1 millimeter in a direction parallel to a direction of elongation of the substrate layer. In an embodiment, a portion of the deposition layer is exposed in the unpatterned region of the resist layer. In an embodiment, the substrate layer comprises bare silicon. In an embodiment, the patterned region comprises a pattern to be transferred from the resist layer to the deposition layer using the etch tool.

In an embodiment, there is provided a method of adjusting one or more substrate manufacturing variables, comprising: evaluating a pattern on a substrate after the substrate has been processed by a post-lithography process tool, wherein the substrate comprises a substrate layer and a deposition layer, and wherein the deposition layer comprises a patterned region and a blank region, the blank region sized to enable an etch rate to be determined thereof during etching of the deposition layer; determining an error between the pattern and a target pattern; and creating, by a hardware computer system, modification information to adjust the post-lithography process tool and/or adjust a process apparatus upstream or downstream from the post-lithography process tool, based at least in part on the error.

In an embodiment, the method further comprises etching the deposition layer with an etch tool; and determining, using the blank region, an etch rate of the etch tool. In an embodiment, determining the etch rate of the etch tool comprises: measuring a first thickness of the blank region at a first time; measuring a second thickness of the blank region at a second time; and determining the etch rate of the etch tool based on a difference between the first thickness and the second thickness and a length of time between the first time and the second time when the substrate is being processed by etch tool. In an embodiment, the modification information is based further at least in part the etch rate of the etch tool. In an embodiment, the blank region has a dimension of at least 1 millimeter in a direction parallel to a direction of elongation of the substrate layer. In an embodiment, the blank region has a post-etch thickness of zero. In an embodiment, the evaluating the pattern on the substrate comprises obtaining a measurement of at least one characteristic of the pattern on the substrate. In an embodiment, the at least one characteristic of the pattern comprises a critical dimension of the pattern or an overlay error of the pattern. In an embodiment, the pattern is located at the patterned region of the deposition layer on the substrate. In an embodiment, the determining the error comprises determining a spatial distribution of the error across the substrate. In an embodiment, the error is a critical dimension error. In an embodiment, the error is an overlay error. In an embodiment, the post-lithography process tool is an etch tool, a track, a chemical mechanical planarization (CMP) tool, or a deposition tool. In an embodiment, the post-lithography process tool is an etch tool, the pattern having been processed by a first etch chamber of the etch tool, and the target pattern having been processed by a second etch chamber of the etch tool. In an embodiment, the modification information comprises information for adjusting at least one variable of the first etch chamber or the second etch chamber. In an embodiment, the at least one variable comprises an etch type or an etch rate. In an embodiment, the process apparatus upstream or downstream from the post-lithography process tool comprises a process apparatus selected from: a deposition tool, a track tool, and/or a lithographic apparatus. In an embodiment, the modification information is used to modify a variable of the post-lithography process tool and/or a process apparatus upstream or downstream from the post-lithography process tool, and wherein the variable comprises a deposition variable of a deposition tool, a track variable of a track, a lithography variable of a lithographic apparatus, an etch variable of an etch tool, or a planarization variable of a CMP tool. In an embodiment, the variable comprises the track variable of the track, the track variable comprising a bake temperature of a bake tool of the track or a development variable of a development tool of the track. In an embodiment, the variable comprises the lithography variable of the lithographic apparatus, the lithography variable comprising a dose or a focus. In an embodiment, the variable comprises the etch variable of the etch tool, the etch variable comprising an etch type of the etch tool or the etch rate of the etch tool. In an embodiment, the substrate layer comprises bare silicon.

In an embodiment, there is provided a method of adjusting one or more substrate manufacturing variables, comprising: providing a patterned substrate that includes a substrate layer, a deposition layer on the substrate layer, and a resist layer on the deposition layer, the resist layer having a first patterned region and a first blank region; etching the deposition layer with an etch tool; and determining an etch rate of the etch tool based on the etching of the deposition layer.

In an embodiment, the deposition layer comprises a second patterned region and a second blank region after being etched. In an embodiment, the method further comprises removing the photoresist layer after the etching, and evaluating at least one characteristic of the second patterned region. In an embodiment, the method further comprises determining an error between the at least one characteristic of the second patterned region and at least one target, and creating, with a computer system, modification information for adjusting the etch tool and/or adjusting one or more process apparatuses upstream from the etch tool based on the error and the etch rate. In an embodiment, the determining the etch rate of the etch tool comprises: measuring a first thickness of the second blank region at a first time; measuring a second thickness of the second blank region at a second time; and determining the etch rate of the etch tool based on a difference between the first thickness and the second thickness and a length of time between the first time and the second time when the deposition layer is being processed by the etch tool. In an embodiment, the first blank region and the second blank region have a dimension of at least 1 millimeter in a direction parallel to a substrate layer underneath the deposition layer. In an embodiment, the substrate layer comprises bare silicon. In an embodiment, the first blank region has a thickness of zero. In an embodiment, the second blank region has a post-etch thickness of zero. In an embodiment, the evaluating the at least one characteristic of the second patterned region comprises obtaining a measurement of the at least one characteristic of a pattern in the second patterned region. In an embodiment, the at least one characteristic of the pattern comprises a critical dimension of the pattern or an overlay of the pattern. In an embodiment, the determining the error comprises determining a spatial distribution of the error across the patterned substrate. In an embodiment, the error is a critical dimension error. In an embodiment, the error is an overlay error. In an embodiment, the patterned region has been processed by a first etch chamber of the etch tool, and the at least one target is at least one characteristic of another patterned region processed by a second etch chamber of the etch tool. In an embodiment, the modification information comprises information for adjusting at least one variable of the first etch chamber or the second etch chamber. In an embodiment, the at least one variable comprises an etch type or an etch rate. In an embodiment, the one or more process apparatuses upstream or downstream from the etch tool comprises one or more selected from: a deposition tool, a track tool, and/or a lithographic apparatus. In an embodiment, the modification information is used to modify one or more variables of the etch tool and/or one or more process apparatuses upstream or downstream from the etch tool, and wherein the one or more variables comprise one or more deposition variables of a deposition tool, one or more track variables of a track, one or more lithography variables of the lithographic apparatus, and one or more etch variables of the etch tool. In an embodiment, the one or more variables comprise the one or more track variables of the track, the one or more track variables comprising a bake temperature of a bake tool of the track or a development variable of a development tool of the track. In an embodiment, the one or more variables comprise the one or more lithography variables of the lithographic apparatus, the one or more lithography variables comprising a dose or a focus. In an embodiment, the one or more variables comprise the one or more etch variables of the etch tool, the one or more etch variables comprising an etch type of the etch tool or the etch rate of the etch tool.

While discussion in this application will consider an embodiment of a metrology process and metrology target designed to measure overlay between one or more layers of a device being formed on a substrate, the embodiments herein are equally applicable to other metrology processes and targets, such as process and targets to measure alignment (e.g., between a patterning device and a substrate), process and targets to measure critical dimension, etc. Accordingly, the references herein to overlay metrology targets, overlay data, etc. should be considered as suitably modified to enable other kinds of metrology processes and targets.

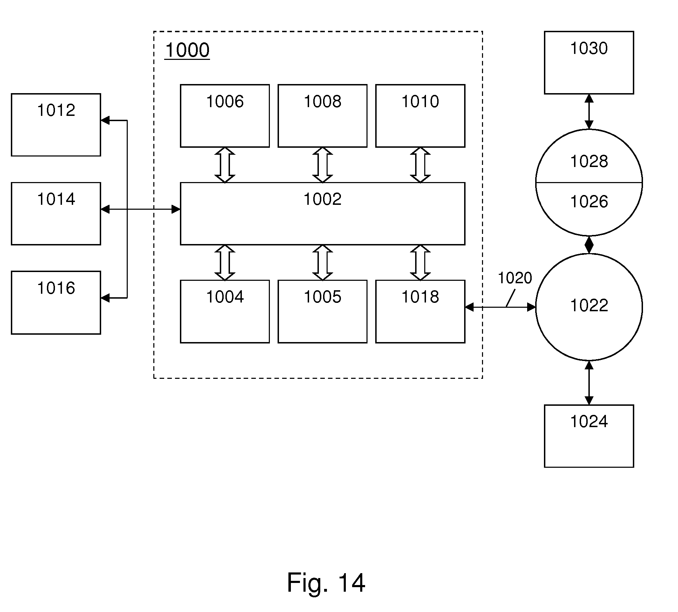

Referring to Figure 14, a computer system 1000 is shown. The computer system 1000 includes a bus 1002 or other communication mechanism for communicating information, and a processor 1004 (or multiple processors 1004 and 1005) coupled with bus 1002 for processing information. Computer system 1000 also includes a main memory 1006, such as a random access memory (RAM) or other dynamic storage device, coupled to bus 1002 for storing information and instructions to be executed by processor 1004. Main memory 1006 also may be used for storing temporary variables or other intermediate information during execution of instructions to be executed by processor 1004. Computer system 1000 further includes a read only memory (ROM) 1008 or other static storage device coupled to bus 1002 for storing static information and instructions for processor 1004. A storage device 1010, such as a magnetic disk or optical disk, is provided and coupled to bus 1002 for storing information and instructions.

Computer system 1000 may be coupled via bus 1002 to a display 1012, such as a cathode ray tube (CRT) or flat panel or touch panel display for displaying information to a computer user. An input device 1014, including alphanumeric and other keys, is coupled to bus 1002 for communicating information and command selections to processor 1004. Another type of user input device is cursor control 1016, such as a mouse, a trackball, or cursor direction keys for communicating direction information and command selections to processor 1004 and for controlling cursor movement on display 1012. This input device typically has two degrees of freedom in two axes, a first axis (e.g., x) and a second axis (e.g., y), that allows the device to specify positions in a plane. A touch panel (screen) display may also be used as an input device.

The computer system 1000 may be suitable to function as the software application 650 in Fig. 10 in response to processor 1004 executing one or more sequences of one or more instructions contained in main memory 1006. Such instructions may be read into main memory 1006 from another computer-readable medium, such as storage device 1010. Execution of the sequences of instructions contained in main memory 1006 causes processor 1004 to perform the process implemented by the software application 650 as described herein. One or more processors in a multi-processing arrangement may also be employed to execute the sequences of instructions contained in main memory 1006. In alternative embodiments, hard-wired circuitry may be used in place of or in combination with software instructions. Thus, embodiments are not limited to any specific combination of hardware circuitry and software.

The term "computer-readable medium" as used herein refers to any medium that participates in providing instructions to processor 1004 for execution. Such a medium may take many forms, including but not limited to, non-volatile media, volatile media, and transmission media. Non-volatile media include, for example, optical or magnetic disks, such as storage device 1010. Volatile media include dynamic memory, such as main memory 1006. Transmission media include coaxial cables, copper wire and fiber optics, including the wires that comprise bus 1002. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1004 for execution. For example, the instructions may initially be borne on a magnetic disk of a remote computer. The remote computer can load the instructions into its dynamic memory and send the instructions over a telephone line using a modem. A modem local to computer system 1000 can receive the data on the telephone line and use an infrared transmitter to convert the data to an infrared signal. An infrared detector coupled to bus 1002 can receive the data carried in the infrared signal and place the data on bus 1002. Bus 1002 carries the data to main memory 1006, from which processor 1004 retrieves and executes the instructions. The instructions received by main memory 1006 may optionally be stored on storage device 1010 either before or after execution by processor 1004.

Computer system 1000 may also include a communication interface 1018 coupled to bus 1002. Communication interface 1018 provides a two-way data communication coupling to a network link 1020 that is connected to a local network 1022. For example, communication interface 1018 may be an integrated services digital network (ISDN) card or a modem to provide a data communication connection to a corresponding type of telephone line. As another example, communication interface 1018 may be a local area network (LAN) card to provide a data communication connection to a compatible LAN. Wireless links may also be implemented. In any such implementation, communication interface 1018 sends and receives electrical, electromagnetic or optical signals that carry digital data streams representing various types of information.

Network link 1020 typically provides data communication through one or more networks to other data devices. For example, network link 1020 may provide a connection through local network 1022 to a host computer 1024 or to data equipment operated by an Internet Service Provider (ISP) 1026. ISP 1026 in turn provides data communication services through the worldwide packet data communication network, now commonly referred to as the "Internet" 1028. Local network 1022 and Internet 1028 both use electrical, electromagnetic or optical signals that carry digital data streams. The signals through the various networks and the signals on network link 1020 and through communication interface 1018, which carry the digital data to and from computer system 1000, are exemplary forms of carrier waves transporting the information.

Computer system 1000 can send messages and receive data, including program code, through the network(s), network link 1020, and communication interface 1018. In the Internet example, a server 1030 might transmit a requested code for an application program through Internet 1028, ISP 1026, local network 1022 and communication interface 1018. In accordance with one or more embodiments, one such downloaded application provides for a method as disclosed herein, for example. The received code may be executed by processor 1004 as it is received, and/or stored in storage device 1010, or other non-volatile storage for later execution. In this manner, computer system 1000 may obtain application code in the form of a carrier wave.

An embodiment of the disclosure may take the form of a computer program containing one or more sequences of machine-readable instructions describing a method as disclosed herein, or a data storage medium (e.g. semiconductor memory, magnetic or optical disk) having such a computer program stored therein. Further, the machine readable instruction may be embodied in two or more computer programs. The two or more computer programs may be stored on one or more different memories and/or data storage media.

Any controllers described herein may each or in combination be operable when the one or more computer programs are read by one or more computer processors located within at least one component of the lithographic apparatus. The controllers may each or in combination have any suitable configuration for receiving, processing, and sending signals. One or more processors are configured to communicate with the at least one of the controllers. For example, each controller may include one or more processors for executing the computer programs that include machine-readable instructions for the methods described above. The controllers may include data storage medium for storing such computer programs, and/or hardware to receive such medium. So the controller(s) may operate according the machine readable instructions of one or more computer programs. Although specific reference may be made in this text to the use of inspection apparatus in the manufacture of ICs, it should be understood that the inspection apparatus described herein may have other applications, such as the manufacture of integrated optical systems, guidance and detection patterns for magnetic domain memories, flat-panel displays, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the disclosure in the context of optical lithography, it will be appreciated that the disclosure may be used in other applications, for example nanoimprint lithography, and where the context allows, is not limited to optical lithography. In the case of nanoimprint lithography, the patterning device is an imprint template or mold. The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

References herein to crossing or passing a threshold may include something having a value lower than a specific value or lower than or equal to a specific value, something having a value higher than a specific value or higher than or equal to a specific value, something being ranked higher or lower than something else (through e.g., sorting) based on, e.g., a parameter, etc.

References herein to correcting or corrections of an error include eliminating the error or reducing the error to within a tolerance range.

The term "optimizing" and "optimization" as used herein refers to or means adjusting a lithographic apparatus, a patterning process, etc. such that results and/or processes of lithography or patterning processing have more a desirable characteristic, such as higher accuracy of projection of a design layout on a substrate, a larger process window, etc. Thus, the term "optimizing" and "optimization" as used herein refers to or means a process that identifies one or more values for one or more variables that provide an improvement, e.g. a local optimum, in at least one relevant metric, compared to an initial set of one or more values for those one or more variables. "Optimum" and other related terms should be construed accordingly. In an embodiment, optimization steps can be applied iteratively to provide further improvements in one or more metrics.

In an optimization process of a system, a figure of merit of the system or process can be represented as a cost function. The optimization process boils down to a process of finding a set of parameters (design variables) of the system or process that optimizes (e.g., minimizes or maximizes) the cost function. The cost function can have any suitable form depending on the goal of the optimization. For example, the cost function can be weighted root mean square (RMS) of deviations of certain characteristics (evaluation points) of the system or process with respect to the intended values (e.g., ideal values) of these characteristics; the cost function can also be the maximum of these deviations (i.e., worst deviation). The term "evaluation points" herein should be interpreted broadly to include any characteristics of the system or process. The design variables of the system can be confined to finite ranges and/or be interdependent due to practicalities of implementations of the system or process. In the case of a lithographic apparatus or patterning process, the constraints are often associated with physical properties and characteristics of the hardware such as tunable ranges, and/or patterning device manufacturability design rules, and the evaluation points can include physical points on a resist image on a substrate, as well as non-physical characteristics such as dose and focus.

While specific embodiments of the disclosure have been described above, it will be appreciated that the disclosure may be practiced otherwise than as described. For example, the disclosure may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the disclosure as described without departing from the scope of the claims set out below.

**Claims**

1. A substrate, comprising:

   a substrate layer; and
   an etchable layer on the substrate layer, the etchable layer comprising a patterned region thereon or therein and comprising a blank region of sufficient size to enable an etch rate of an etch tool for etching the blank region to be determined.

2. The substrate of claim 1, further comprising a resist layer on the etchable layer, the resist layer comprising the patterned region.

3. The substrate of claim 2, wherein the patterned region comprises a pattern to be transferred from the resist layer to the etchable layer using the etch tool.

4. The substrate of claim 2 or claim 3, wherein the resist layer comprises an open region to expose the blank region to an etchant of the etch tool, the open region being of sufficient size to enable the etch rate of the etch tool for etching the blank region to be determined.

5. The substrate of any of claims 1-4, wherein the blank region has a dimension of at least 1 millimeter in a direction parallel to a direction of elongation of the substrate layer.

6. The substrate of any of claims 1-5, wherein the blank region has a post-etch thickness of zero.

7. The substrate of any of claims 1-6, wherein the substrate layer comprises bare silicon.

8. The substrate of any of claims 1-7, wherein the patterned region comprises a pattern to be measured by a metrology apparatus.

9. A method, comprising:

   providing a substrate that includes a substrate layer and an etchable layer on the substrate layer, the etchable layer having a first patterned region thereon or therein and a blank region;
   etching, with an etch tool, at least part of the patterned region to form a second patterned region in the etchable layer; and
   evaluating a characteristic of the second patterned region; and
   creating and outputting, by a hardware computer system, information regarding the etch tool based on the evaluated characteristic.

10. The method of claim 9, wherein the evaluating comprises determining a deviation between a value of the evaluated characteristic of the second patterned region and a target value of the characteristic, and wherein the creating and outputting comprises creating modification information, based on the deviation, to adjust the etch tool and/or adjust a process apparatus upstream or downstream from the etch tool.

11. The method of claim 10, wherein the process apparatus upstream or downstream from the etch tool comprises one or more selected from: a deposition tool, another etch tool, a track tool, a chemical mechanical planarization (CMP) tool, and/or a lithography tool.

12. The method of claim 10 or claim 11, wherein the modification information is used to modify a variable of the etch tool and/or another process apparatus upstream or downstream from the etch tool, and wherein the variable comprises a deposition variable of a deposition tool, a track variable of a track, a lithography variable of a lithographic apparatus, an etch variable of another etch tool, and/or a planarization variable of a CMP tool.

13. The method of claim 12, wherein the variable comprises the track variable of the track, the track variable comprising a bake temperature of a bake tool of the track or a development variable of a development tool of the track.

14. The method of claim 12 or claim 13, wherein the variable comprises the lithography variable of the lithographic apparatus, the lithography variable comprising a dose or a focus.

15. The method of any of claims 12-14, wherein the variable comprises the etch variable of the etch tool, the etch variable comprising an etch type of the etch tool or an etch rate of the etch tool.

16. The method of any of claims 10-15, wherein the creating modification information comprises creating modification to adjust a variable of a first etch chamber of the etch tool separately from a second etch chamber of the etch tool.

17. The method of any of claims 10-16, wherein the evaluating comprises determining a spatial distribution of the value of the characteristic of the evaluated pattern or of a deviation between the value of the characteristic of the evaluated pattern and a target value of the characteristic, across the substrate.

18. The method of any of claims 9-17, wherein the second patterned region is generated by a first etch chamber of the etch tool, and the target value is for a second etch chamber of the etch tool.

19. The method of any of claims 9-18, wherein the evaluating the characteristic of the second patterned region comprises obtaining a measurement of a value of the characteristic of a pattern in the second patterned region.

20. The method of any of claims 9-19, wherein the characteristic of the second patterned region comprises one or selected from: critical dimension, overlay, side wall angle, bottom surface tilt, pattern feature height, layer thickness, pattern shift, geometric asymmetry and/or one or more other geometrical parameters.

21. The method of any of claims 9-20, wherein the blank region has a dimension of at least 1 millimeter in a direction parallel to a direction of elongation of the substrate layer.

22. The method of any of claims 9-21, wherein the first patterned region comprises a pattern in a resist layer on the etchable layer.

23. The method of any of claims 9-22, further comprising determining an etch rate of the etch tool based on etching of at least part of the blank region of the etchable layer.

**24.** The method of claim 23, comprising creating modification information, based at least in part on the etch rate, to adjust the etch tool and/or adjust a process apparatus upstream or downstream from the etch tool.

**25.** The method of claim 23 or claim 24, wherein determining the etch rate comprises:

measuring a first thickness of the blank region at a first time;
measuring a second thickness of the blank region at a second time; and
determining the etch rate of the etch tool based on a difference between the first thickness and the second thickness and a length of time between the first time and the second time when the etchable layer is being processed by the etch tool.

**26.** A method, comprising:

evaluating a pattern on a substrate after the substrate has been processed by a process tool upstream or downstream from a lithography tool, to determine a value of a characteristic of the evaluated pattern;
determining whether the value of the characteristic of the evaluated pattern meets a target value of the characteristic; and
responsive to a determination that the value of the characteristic of the evaluated pattern does not meet the target value of the characteristic, creating and outputting, by a hardware computer system and based at least in part on the determination, information regarding the process tool.

**27.** The method of claim 26, wherein the determining comprises determining a deviation between the value of the characteristic of the evaluated pattern and the target value of the characteristic and the creating and outputting comprises creating, based at least in part on the deviation, modification information to adjust the process tool and/or another process apparatus upstream or downstream from the process tool.

**28.** The method of claim 27, wherein the process apparatus upstream or downstream from the process tool comprises one or more selected from: a deposition tool, a track tool, an etch tool, a chemical mechanical planarization (CMP) tool, and/or the lithography tool.

**29.** The method of claim 27 or claim 28, wherein the modification information is used to modify a variable of the process tool and/or another process apparatus upstream or downstream from the process tool, and wherein the variable comprises a deposition variable of a deposition tool, a track variable of a track, a lithography variable of a lithographic apparatus, an etch variable of an etch tool, and/or a planarization variable of a CMP tool.

**30.** The method of claim 29, wherein the variable comprises the track variable of the track, the track variable comprising a bake temperature of a bake tool of the track or a development variable of a development tool of the track.

**31.** The method of claim 29 or claim 30, wherein the variable comprises the lithography variable of the lithographic apparatus, the lithography variable comprising a dose or a focus.

**32.** The method of any of claims 29-31, wherein the variable comprises the etch variable of the etch tool, the etch variable comprising an etch type of the etch tool or an etch rate of the etch tool.

**33.** The method of any of claims 27-32, wherein the determining comprises determining a spatial distribution of the value of the characteristic of the evaluated pattern or of a deviation between the value of the characteristic of the evaluated pattern and the target value of the characteristic, across the substrate.

**34.** The method of any of claims 27-33, wherein the creating modification information comprises creating modification to adjust a variable of a first component of the process tool separately from a second component of the process tool.

**35.** The method of any of claims 26-34, wherein the process tool is an etch tool, the pattern having been processed by a first etch chamber of the etch tool, and the target value being for a second etch chamber of the etch tool.

**36.** The method of any of claims 26-35, wherein the process tool is an etch tool, a track, a chemical mechanical planarization (CMP) tool, or a deposition tool.

**37.** The method of claim 36, wherein the process tool comprises an etch tool.

**38.** The method of claim 37, wherein the substrate comprises a substrate layer and an etchable layer, and wherein the etchable layer comprises a patterned region therein or thereon and a blank region, the blank region sized to enable an etch rate of the etch tool to be determined.

**39.** The method of claim 38, further comprising:

etching at least blank region of the etchable layer with an etch tool; and
determining, using the etched blank region, the etch rate of the etch tool.

**40.** The method of claim 39, wherein the determining the etch rate of the etch tool comprises:

measuring a first thickness of the blank region at a first time;
measuring a second thickness of the blank region at a second time; and
determining the etch rate of the etch tool based on a difference between the first thickness and the second thickness and a length of time between the first time and the second time when the substrate is being processed by the etch tool.

**41.** The method of any of claims 38-40, wherein the blank region has a dimension of at least 1 millimeter in a direction parallel to the substrate layer.

**42.** The method of any of claims 38-41, comprising creating, based at least in part on the determined etch rate, modification information to adjust the process tool.

**43.** The method of any of claims 26-42, wherein evaluating the pattern on the substrate comprises obtaining a measurement of the value of the characteristic of the pattern on the substrate.

**44.** The method of any of claims 26-43, wherein the characteristic of the pattern comprises one or selected from: critical dimension, overlay, side wall angle, bottom surface tilt, pattern feature height, layer thickness, pattern shift, geometric asynmietry and/or one or more other geometrical parameters.

**45.** A non-transitory computer program product comprising machine-readable instructions for causing a processor system to cause performance of the method of any of claims 9-44.

**46.** A system comprising:

a hardware processor system; and
a non-transitory computer readable storage medium configured to store machine-readable instructions, wherein when executed, the machine-readable instructions cause the hardware processor system to perform the method of any of claims 9-44.

Fig. 1

Fig. 2

(a)

(b)    (c)    (d)

Fig. 3

Fig. 4

Fig. 5

Fig. 6

605

— 705

FIG. 7A

615

— 710

— 705

FIG. 7B

615

715

710

705

FIG. 7C

635

720        730

725

715

710

705

FIG. 7D

645

720 730

745

735

715
710
705

FIG. 7E

645

740 750

745

735

710
705

FIG. 7F

FIG. 7G

Fig. 8

Fig. 9

Fig. 10

PU

180

110

120

130 170

2

Z

Y

X

F

140

160

150

S

W

30

**Fig. 11**

W

L

S

30

a

**Fig. 12**

Fig. 13

EP 3 291 008 A1

Fig. 14

Europäisches
Patentamt

European
Patent Office

Office européen
des brevets

# EUROPEAN SEARCH REPORT

Application Number

EP 16 18 7478

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/237588 A1 (LEHR MATTHIAS [DE]) 2 October 2008 (2008-10-02) | 1-11 | INV. G03F7/20 |
| A | * the whole document * * paragraphs [0035], [0040], [0060] * * figure 2b * | 12-15 | |
| X | WO 2013/177576 A1 (UNIV CALIFORNIA [US]) 28 November 2013 (2013-11-28) | 1-6,8,9 | |
| A | * page 15 * * figure 7 * | 10 | |
| X | US 2006/099816 A1 (DALTON TIMOTHY J [US] ET AL) 11 May 2006 (2006-05-11) * figure 4 * | 1,7 | |
| X | US 2005/202327 A1 (GOODWIN FRANCIS [US]) 15 September 2005 (2005-09-15) | 1 | |
| A | * figures 3, 8,12 * | 13,14 | |
| X | US 6 316 169 B1 (VAHEDI VAHID [US] ET AL) 13 November 2001 (2001-11-13) * figures 1,2 * | 1 | |
| A | WO 2010/110878 A1 (TOKYO ELECTRON LTD [JP]; KINTAKA HIROKI [US]; OZU TOSHIHISA [JP]; TAKA) 30 September 2010 (2010-09-30) * paragraphs [0043] - [0048] * | 13 | TECHNICAL FIELDS SEARCHED (IPC) G03F H01L |

The present search report has been drawn up for all claims

| Place of search | Date of completion of the search | Examiner |
|---|---|---|
| The Hague | 9 May 2017 | Gijsbertsen, Hans |

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☒ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

## ANNEX TO THE EUROPEAN SEARCH REPORT
## ON EUROPEAN PATENT APPLICATION NO.

EP 16 18 7478

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2017

| Patent document cited in search report | | Publication date | Patent family member(s) | | Publication date |
|---|---|---|---|---|---|
| US 2008237588 | A1 | 02-10-2008 | DE 102007015506 A1<br>US 2008237588 A1<br>US 2011020958 A1 | | 02-10-2008<br>02-10-2008<br>27-01-2011 |
| WO 2013177576 | A1 | 28-11-2013 | US 2015118604 A1<br>WO 2013177576 A1 | | 30-04-2015<br>28-11-2013 |
| US 2006099816 | A1 | 11-05-2006 | CN 1783438 A<br>US 2006099816 A1<br>US 2007143721 A1 | | 07-06-2006<br>11-05-2006<br>21-06-2007 |
| US 2005202327 | A1 | 15-09-2005 | NONE | | |
| US 6316169 | B1 | 13-11-2001 | TW 490712 B<br>US 6316169 B1<br>US 2002018965 A1 | | 11-06-2002<br>13-11-2001<br>14-02-2002 |
| WO 2010110878 | A1 | 30-09-2010 | CN 102365392 A<br>JP 2012521659 A<br>KR 20120001773 A<br>TW 201108324 A<br>WO 2010110878 A1 | | 29-02-2012<br>13-09-2012<br>04-01-2012<br>01-03-2011<br>30-09-2010 |

EPO FORM P0459

For more details about this annex : see Official Journal of the European Patent Office, No. 12/82

**EP 3 291 008 A1**

**REFERENCES CITED IN THE DESCRIPTION**

**Patent documents cited in the description**

- WO 2009078708 A
- WO 2009106279 A
- US 20110027704 A
- US 20110043791 A
- US 20120242970 A
- US 2006066855 A